(19) Europäisches Patentamt
European Patent Office
Office européen des brevets

(11) EP 0 540 153 B1

(12) EUROPEAN PATENT SPECIFICATION

(45) Date of publication and mention of the grant of the patent:
**09.06.1999 Bulletin 1999/23**

(51) Int Cl.[6]: **G11C 7/00**, G11C 11/22, G11C 13/02, G02F 1/13

(21) Application number: **92308163.2**

(22) Date of filing: **09.09.1992**

# (54) A non-volatile memory device

Nichtflüchtige Speicheranordnung

Dispositif de mémoire non-volatile

(84) Designated Contracting States:
**DE FR GB NL**

(30) Priority: **30.10.1991 JP 28513591**
**30.10.1991 JP 28513691**
**01.11.1991 JP 28767291**
**10.06.1992 EP 92305294**

(43) Date of publication of application:
**05.05.1993 Bulletin 1993/18**

(73) Proprietor: **SHARP KABUSHIKI KAISHA**
**Osaka-shi, Osaka-fu 545-0013 (JP)**

(72) Inventors:
- **Yoshitaka, Yamamoto**
  **Yamotokoriyama-shi, Nara-ken (JP)**
- **Yutaka, Ishii**
  **Nara-shi, Nara-ken (JP)**

(74) Representative: **Suckling, Andrew Michael et al**
**Marks & Clerk,**
**Nash Court,**
**Oxford Business Park South**
**Oxford OX4 2RU (GB)**

(56) References cited:
**EP-A- 0 127 140** **DE-A- 3 707 280**
**US-A- 3 836 243**

- **DIGEST OF PAPERS: COMPCON SPRING 84; SAN FRANCISCO;USA pages 110 - 114 CARTER 'PROSPECTS FOR COMPUTATION AT THE MOLECULAR SIZE LEVEL.'**
- **OPTICAL COMPUTING & PROCESSING vol. 1, no. 1, March 1991, LONDON pages 13 - 21 BOWRY E.A. 'LIQUID CRYSTAL POLYMER OPTICAL MEMORIES: ANALOGUE, DIGITAL AND HOLOGRAPHIC.'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 540 153 B1

## Description

1. Field of the Invention:

The present invention relates to a non-volatile memory device with a large capacity and a high density. More particularly, the present invention relates to a non-volatile memory device adapted for use in a computer, a memory card, a wordprocessor, and the like.

2. Description of the Prior Art:

As non-volatile memory devices, the following four are well known and widely used:

(1) Magnetic tape,
(2) Magnetic disc,
(3) IC non-volatile memory such as EPROM and EEPROM, and
(4) Optical magnetic disc.

Each of these devices will be more particularly described.

(1) Magnetic tape:

A magnetic tape is a most typical rewritable non-volatile memory device. It is in wide use for an audio tape and a video tape because of its low price and also is used for a back-up memory of a computer because of its very large capacity.
The magnetic tape has disadvantages of performing only sequential data writing and reading and of long access time.

(2) Magnetic disc:

A magnetic disc is generally used for an external memory device of a computer or a wordprocessor. Magnetic discs include a floppy disc which is easy to handle and inexpensive and a hard disc which has a larger capacity but is harder to handle and more expensive than a floppy disc.
A magnetic disc has advantages of a high-speed random access and relatively easy data writing and rewriting.
The magnetic disc has a limit in improving the capacity and the density. For example, the capacity of a 3.5-inch floppy disc is approximately 1 megabyte, and that of a 3.5-inch hard disc is approximately 40 megabytes.

(3) EPROM and EEPROM:

EPROM and EEPROM are representative IC non-volatile memory devices, which are rewritable and are capable of high density writing. In the EPROM, writing is electrically effected and erasing is effected by ultraviolet irradiation. In the EEPROM, both writing and erasing are electrically effected. These IC non-volatile memory devices have advantages such as compactness, lightness, short access time and low power consumption.
The EEPROM, which is capable of electrical writing and erasing, will be described in detail. Figure 20 is a cross sectional view of a memory cell of an EEPROM. The memory cell includes a silicon substrate **7**, a gate oxide film **5** provided on the silicon substrate **7**, and a floating gate **4** and a control gate **2** provided on the gate oxide film **5**. The floating gate **4** has a function of accumulating and keeping carriers. The control gate **2** has a function of controlling injection of the carriers to the floating gate **4**. The floating gate **4** and the control gate **2** are insulated from each other by an insulating film **3** formed of silicon oxide. On the silicon substrate **7**, a surface passivation film **1** is provided so as to cover the floating gate **4** and the control gate **2**. The surface passivation film **1** is usually formed of silicon oxide or silicon nitride. The silicon substrate **7** has a source area **8** and a drain area **6** formed by impurity injection at upper portions thereof. A channel area **9** is provided between the source area **8** and the drain area **6**.
For writing data in an EEPROM having the above construction, a voltage is applied between the drain area **6** and the control gate **2**, and carriers are injected to the floating gate **4** through the gate oxide film **5**. For erasing the data, a voltage is applied between the source area **8** and the control gate **2**, and the carriers are removed utilizing the Fowler-Nordheim (N-F) Tunneling phenomenon. For reading the data, ON or OFF is judged based on a threshold of the inverting voltage at the channel area **9** between the source area **8** and the drain area **6**.
In the above construction, since carrier injection and removal are done through the gate oxide film **5**, the quality and the thickness of the gate oxide film **5** are very important. In an EEPROM having a memory capacity of 1

megabit, the gate oxide film **5** usually has a thickness of approximately 20 nm. Accordingly, it is difficult to control the quality and the thickness thereof, causing a serious problem that the production cost is increased due to the decline of the yield. Both long and short sides of an EEPROM chip are usually 7 to 10 mm. An enlargement of the size in order to increase the memory capacity lowers the yield and thus raises the production cost.

For the above problems, the EEPROM is limited in improving the memory capacity. The average memory capacity of the EEPROMs used today is approximately 1 to 4 megabits, which is smaller than the other non-volatile memory devices such as a magnetic disc and an optical magnetic disc.

(4) Optical magnetic disc:

An optical magnetic disc capable of rewriting is one of the representative large capacity non-volatile memory devices.

Figure 21 shows a construction of an optical magnetic disc. The optical magnetic disc includes magnetic thin films **15** and **16** as memory mediums. The magnetic thin films **15** and **16** show perpendicular magnetization. For writing data, a laser beam **20** is converged to a ccnvergence area **21** in a weak magnetic field which has an opposite polarity to that of the magnetic field to which the magnetic thin films **15** and **16** have been magnetized. Data is written in the magnetic thin films **15** and **16** by local heating. Data reading is effected utilizing the Kerr effect or the Faraday effect. In more detail, when the laser beam **20** which is linearly polarized is emitted to the disc, the plane of polarization of light transmitted through or reflected by the disc is rotated in accordance with the condition of magnetization of the magnetic thin films **15** and **16**. Such a rotation of the plane of polarization is converted into an optical signal using an analyzer and then is detected by a photo detector as an electric signal. Thus, the data is read out. The optical magnetic disc is practically used for a large capacity memory device for document files and image files.

In the optical magnetic disc, writing can be done without contact by emitting the laser beam **20** through a transparent glass substrate **12**. Accordingly, dust on a writing plane **23** causes no problem. Since the laser beam **20** is not focused on a surface **22** of the glass substrate **12,** the laser beam **20** has a large diameter of several hundred microns at the surface **22.** Accordingly, the presence of dust here does not have any serious effect.

Owing to the writing and reading by use of the converged laser beam **20**, high density writing is realized. For example, a 3.5-inch disc has a large capacity of approximately 120 megabytes.

A disadvantage of the optical magnetic disc is that a rotating mechanism required for rotating the disc enlarges the writing and reading apparatus and thus increases the production cost.

Conventional rewritable non-volatile memory devices have the above-mentioned advantages and disadvantages. An ideal non-volatile memory device must fulfill the following four requirements, which cannot be achieved by any conventional device for the following reasons.

(1) Large capacity and high density:

A floppy disc cannot meet this requirement as is apparent from the fact that a 3.5-inch floppy disc has a capacity of only 1 megabyte.

IC non-volatile memory devices such as an EPROM or an EEPROM can realize high density, but not a large capacity due to the restriction of the area thereof.

(2) Resistance against impact and vibration:

In the case of a hard disc, a large capacity can be realized by integrating a plurality of discs. In this case, however, the distance between a head and the disc is as microscopic as 1 micron or less. Such a device is easily destroyed by impact, vibration, or even microscopic dust adhering on the head or the disc.

(3) Compact, simple and inexpensive device for writing and reading:

Since a floppy disc, a hard disc and an optical magnetic disc effect writing and reading by rotating a disc, a rotating mechanism such as a motor is required. Accordingly, the writing and reading apparatus is inevitably large and complicated.

In the case of a hard disc, an alleviating material is required in order to guarantee a precise distance between the disc and the head and resistance against impact. The alleviating material enlarges and complicates the writing and reading apparatus.

An optical magnetic disc also requires a large and complicated writing and reading apparatus because of the use of a laser and a magnet.

(4) High-speed writing and reading:

A floppy disc, a hard disc and an optical magnetic disc have a limit in enhancing a reading speed thereof since data is searched by rotating the disc. A magnetic tape is especially slow in writing and reading.

Since no conventional non-volatile memory device fulfills all the four requirements, a completely novel device has been demanded.

US-3 836 243, on which the preambles of claims 1 and 14 are based, discloses a non-volatile memory device comprising: a first substrate and a second substrate disposed parallel with each other with a gap therebetween; a memory medium provided between the first and second substrates and formed of a material selected from the group consisting of a liquid crystal compound and a composite including a liquid crystal component in one molecule: a counter electrode provided on a surface of the first substrate, the surface facing the memory medium; heating means provided on the second substrate and including a plurality of strip-like lower electrodes insulated from one another and arranged in parallel with one another, a plurality of strip-like upper electrodes arranged perpendicular to the lower electrodes. and a heat generating layer sandwiched between the upper and the lower electrodes so as to receive current from the upper and the lower electrodes at intersections thereof, the heating means being provided for writing data into the memory medium by heating the memory medium and thus changing a phase of the memory medium; and reading means for reading the data written into the memory medium.

A first aspect of the present invention provides a non-volatile memory device of the above type and characterised in that it further comprises an electrically insulating film provided on the lower electrodes, the insulating film being provided in regions where the upper electrodes do not overlay the lower electrodes; and in that the reading means is adapted to detect electrically a change in a property of the memory medium using the counter electrode and one or more of the upper electrodes.

A second aspect of the present invention provides a non-volatile memory device, comprising a first substrate and a second substrate disposed parallel with each other with a gap therebetween; a memory medium provided between the first and second substrates and formed of a material selected from the group consisting of a liquid crystal compound and a composite including a liquid crystal component in one molecule; a counter electrode provided on a surface of the first substrate, the surface facing the memory medium: heating means provided on the second substrate and including a plurality of strip-like lower electrodes insulated from one another and arranged in parallel with one another. a plurality of strip-like upper electrodes arranged perpendicular to the lower electrodes, and a heat generating layer sandwiched between the upper and the lower electrodes so as to receive current from the upper and the lower electrodes at intersections thereof, the heating means being provided for writing data into the memory medium by heating the memory medium and thus changing a phase of the memory medium; and reading means for reading the data written into the memory medium optically detecting a phase transition of the memory medium; characterised in that the memory device further comprises an electrically insulating film provided on the lower electrodes, the insulating film being provided in regions where the upper electrodes do not overlay the lower electrodes.

In the non-volatile memory device according to the present invention, data is written by electrically heating a liquid crystal. Owing to this principle, the memory capacity is significantly enhanced and the density is also increased while the size of the apparatus is reduced. Moreover, since a high-speed random access is possible, data writing and reading can be done at a high speed. Writing and reading errors due to impact or vibration do not occur, which improves writing and reading accuracy.

Thus, the invention described herein makes possible the advantage of providing a non-volatile memory device which is capable of a high density, large capacity memory and accurate and high-speed writing and reading, and allows for a compact, simple and inexpensive writing and reading apparatus.

These and other advantages of the present invention will become apparent to those skilled in the art upon reading and understanding the following detailed description with reference to the accompanying figures.

## BRIEF DESCRIPTION OF THE DRAWINGS

Figure **1** is a plan view of a non-volatile memory device according to a first example of the present invention.

Figure **2** is a plan view of a recording section of the non-volatile memory cell according to the first example.

Figure **3** is a cross sectional view of an essential part of the recording section of the non-volatile memory device according to the first example.

Figure **4** is a perspective view of the recording section in the state where a liquid crystal is excluded.

Figure **5** is an equivalent circuit diagram of the non-volatile memory device according to the first example.

Figure **6** is a time chart showing the relationship between the voltage applied to the liquid crystal and the temperature.

Figures **7** through **11** are charts each showing an example of signal waveforms used for reading data from the non-volatile memory device according to the first example.

Figure **12** is a schematic view of an optical reading apparatus used for reading data from the non-volatile memory device according to the first example.
Figure **13** is a graph showing a property of a ferroelectric liquid crystal used in a non-volatile memory device according a second example of the present invention.
Figure **14** is a graph showing the relationship between the temperature of the ferroelectric liquid crystal and the response time.
Figure **15** is a schematic view showing a chemical structure of a conductive polymeric liquid crystal used in a non-volatile memory device according to a fourth example of the present invention.
Figure **16A** is a schematic view of the conductive polymeric liquid crystal in the state where mesogen radicals and charge-transfer complexes are aligned.
Figure **16B** is a schematic view of the conductive polymeric liquid crystal in the state where neither mesogen radicals nor the charge-transfer complexes are aligned.
Figure **17** is a view of an essential part of the non-volatile memory device according to the fourth example in the state where the mesogen radicals and the charge-transfer complexes are aligned.
Figures **18A** and **18B** are views of an essential part of the non-volatile memory device according to the fourth example in the state where neither the mesogen radicals nor the charge-transfer complexes are aligned.
Figure **19** is an equivalent circuit diagram of the non-volatile memory device of the fourth example.
Figure **20** is a cross sectional view of an EEPROM.
Figure **21** is a cross sectional view of an optical magnetic disc.

## DESCRIPTION OF THE PREFERRED EMBODIMENTS

Hereinafter, the present invention will be described by way of illustrative examples with reference to the accompanying drawings.

### Example 1

Figure **1** schematically shows a plan view of a non-volatile memory device according to a first example of the present invention. The non-volatile memory device includes a pair of recording sections **34** each having a plurality of memory cells **43** (Figure **4**) and circuit sections **31** through **33** each provided in pairs around the recording sections **34**. Since the pair of recording sections **34** and the circuit sections **31** through **33** are identical to each other, only one of the pair will be described for simplicity. The circuit sections **31** through **33** have different functions from one another. The circuit section **31** has a function of processing a signal sent from an external device and sending the signal to each memory cell **43** of the recording section **34** as memory data and another function of processing a signal read out from the memory cell **43** and sending the signal to an external device. (Hereinafter, the circuit section **31** will be referred to as the input/output signal controlling section **31**.) The circuit section **32** has a function of entirely controlling signal processing performed in the non-volatile memory device. (Hereinafter, the circuit section **32** will be referred to as the logic controlling section **32**.) The circuit section **33** has a function of controlling an electric current for supplying an electric signal to each memory cell **43** of the recording section **34** in response to an instruction from the logic controlling section **32**. (Hereinafter, the circuit section **33** will be referred to as the driving circuit section **33**.) The recording section **34** has a function of accumulating signals sent from the input/output signal controlling section **31** and storing the signals as memory data.
As is shown in Figure **3**, the recording section **34** includes a silicon substrate **55**, a glass substrate **52** opposed to the silicon substrate **55**, and a liquid crystal layer **53** enclosed between the silicon substrate **55** and the glass substrate **52**. On the silicon substrate **55**, a heat generating layer **44** for heating the liquid crystal layer **53**, and upper electrodes **41** and lower electrodes **42** for generating heat in the heat generating layer **44** in cooperation are provided. On the glass substrate **52,** strip-like counter electrodes **51** are provided. The liquid crystal layer **53** is in electric contact with the upper electrodes **41** through an alignment film **56**, and also with the counter electrodes **51** through another alignment film **56'**.
Figure **4** is a perspective view of the recording section **34** in the state where the glass substrate **52** having the counter electrodes **51** and the liquid crystal layer **53** are excluded. The upper electrodes **41** which are strip-like are arranged in parallel columns with a substantially uniform gap between adjacent upper electrodes **41**. Below the upper electrodes **41**, the lower electrodes **42** which are strip-like are arranged in parallel with a substantially uniform gap between adjacent lower electrodes **42**. The lower electrodes **42** are arranged in rows perpendicular to the upper electrodes **41.** The memory cells **43** are provided at portions of the liquid crystal layer **53**, the portions corresponding to intersections of the upper electrodes **41** and the lower electrodes **42**. As a material for the upper electrodes **41** and the lower electrodes **42,** tungsten which is excellent in heat resistance is used in the first example. A pair of the upper electrode **41** and the lower electrode **42** corresponding to the memory cells **43** to which data is to be written are used

for generating heat in the heat generating layer **44**.

As is mentioned above, the memory cells **43** are opposed to the intersections of the upper electrodes **41** and the lower electrodes **42**. In Figure **2**, the upper electrodes **41** arranged columns are referred to as **U1**, **U2**, **U3**, **U4** and **U5**, and the lower electrodes **42** arranged in rows are referred to as **D1**, **D2** and **D3**. The memory cells are referred to as **Mij** (**i** is a reference number of the upper electrode **41**, and **j** is a reference number of the lower electrode **42**; **i** = 1, 2, 3, 4 and 5; **j** = 1, 2 and 3).

Referring to Figure **3**, a construction of the recording section **34** according to the first example will be described in detail.

On a surface of the glass substrate **52** opposed to the silicon substrate **55**, the counter electrodes **51** are provided. On the counter electrodes **51**, the alignment film **56'** is provided. The liquid crystal layer **53** in contact with the alignment film **56'** has a function of recording data based on a change in the alignment state or a phase transition of the liquid crystal.

The silicon substrate **55** is formed of single crystalline silicon generally used for ICs, to which an impurity is added, in order to control the electrical resistance thereof. A surface of the silicon substrate **55** is covered with a field insulating film **57**, and the lower electrodes **42** are provided on the field insulating film **57**. Thus, a driving current flowing to the lower electrodes **42** is prevented from leaking to the silicon substrate **55**.

Between the upper electrodes **41** and the lower electrodes **42**, an insulating film **54** is provided in order to keep the insulation therebetween. The insulating film **54** is formed of silicon nitride by use of a plasma CVD method in the first example. A voltage of 10 V or higher is possibly applied between a pair of the upper electrode **41** and the lower electrode **42**, even in which case the insulation therebetween is guaranteed since the insulating film **54**, formed of silicon nitride, has a uniform quality with no pinholes and also a uniform thickness.

The insulating film **54** has openings **54a** at portions corresponding to the memory cells **43**. In each opening **54a**, a portion of the heat generating layer **44** interposed between a pair of the upper electrode **41** and the lower electrode **42** is located. Since the heat of the heat generating layer **44** raises the temperature of both the upper electrode **41** and the lower electrode **42** in an operation for writing or erasing memory data, the upper and lower electrodes **41** and **42** must be formed of a material having a high heat resistance. In the first example, the upper and lower electrodes **41** and **42** are formed of tungsten by use of a reduced-pressure CVD method. On the other hand, the heat generating layer **44** must be formed of a material which has an appropriate electrical resistance and is suitable for fine patterning as well as having a high heat resistance. In the first example, the heat generating layer **44** is formed of polysilicon having a high purity by use of a reduced-pressure CVD method.

On the upper electrodes **41** and the heat generating layer **44,** the alignment film **56** is provided. For forming the alignment film **56,** polyimide is coated on the upper electrodes **41** and the heat generating layer **44** and the resultant layer of polyimide is then heated and rubbed. The alignment film **56'** is formed in the same manner. Instead of polyimide, any other material generally used for an alignment film may be used. The alignment films **56** and **56'** may be omitted if an appropriate liquid crystal material and appropriate writing and reading conditions are employed.

The upper and lower electrodes **41** and **42** are formed of tungsten by use of a reduced-pressure CVD method in the first example. Any other material may be used as long as the material is excellent in heat resistance and in chemical resistance, is easy to form and process, and is low in electrical resistance. The reduced-pressure CVD method may be replaced with any other method as long as the electrodes can be formed in a uniform thickness. The heat -generating layer **44** is formed of polysilicon by use of a reduced-pressure CVD method in the first example. Any other material may be used as long as the material has an appropriate electrical resistance, is excellent in heat resistance and chemical resistance, and is easy to form and process. The reduced-pressure CVD method may be replaced with any other method as long as the heat generating layer **44** can be formed in a uniform thickness.

A production process of the recording section **34** will be described in detail. Although the non-volatile memory device includes, as well as the recording section **34**, MOS ICs, namely, the input/output signal controlling section **31**, the logic controlling section **32**, and the driving circuit section **33** in the first example, the production process of only the recording section **34** will be described since the production process of the MOS ICs are known.

As the silicon substrate **55**, a 6-inch p-type (100) single crystalline silicon wafer is used. The field insulating film **57** is formed in a thickness of 800 nm by thermally oxidizing the surface of the silicon substrate **55**. On the field insulating film **57**, the lower electrodes **42** are formed by depositing tungsten into a film having a thickness of 1.2 μm by use of a reduced-pressure CVD method and then patterning the film of tungsten by use of photolithography and dry etching. On the field insulating film **57** having the lower electrodes **42**, the insulating film **54** is formed of silicon nitride by use of a plasma CVD method so as to have a thickness of 1.0 μm on the lower electrodes **42**. Then, the openings **54a** reaching the lower electrodes **42** are formed in the insulating film **54** by use of photolithography and dry etching.

On the insulating film **54** and the lower electrodes **42**, the heat generating layer **44** is formed of polysilicon in a thickness of approximately 1.0 μm by use of a reduced-pressure CVD method so as to have a specific resistance of approximately 1,000 Ω·cm. When the heat generating layer **44** formed of polysilicon is doped with an impurity such as

boron, phosphorus or a metal, the resistance thereof is possibly reduced and thus prevents the temperature thereof from reaching a specified level even when heat is generated. In order to avoid such an inconvenience, highly pure polysilicon and a highly clean CVD device must be used. The heat generating layer **44** is formed by use of a reduced-pressure CVD method with a highly pure mono-silane gas in the first example. Any other silicon compound or any other method may be used as long as a required level of resistance can be obtained.

On the heat generating layer **44**, the upper electrodes **41** are formed by depositing tungsten into a film having a thickness of approximately 1.0 μm by use of a reduced-pressure CVD method and then patterning the film of tungsten by use of photolithography and dry etching. Then, the alignment film **56** is formed on the upper electrodes **41**. For forming the alignment film **56**, polyimide is coated on the upper electrodes **41** by spinning, the resultant layer of polyimide is treated with polymerization by heating, an unnecessary portion is removed, and then the resultant film is rubbed.

The glass substrate **52** is prepared by cutting glass into an appropriate size. On the surface of the glass substrate **52**, the counter electrodes **51** are formed by laminating a transparent conductive film formed of ITO (indium tin oxide) by use of sputtering and then patterning the film of ITO by use of photolithography and etching. The counter electrodes **51** are arranged in rows perpendicular to the upper electrodes **41**. The arranging pitch and the width of the counter electrodes **51** are set to be most suitable for writing and reading data. Then, on the counter electrodes **51,** the alignment film **56'** is formed by polyimide coating by spinning followed by polymerization by heating, removal of an unnecessary portion and then rubbing.

The silicon substrate **55** and the glass substrate **52** having the above-mentioned elements thereon are opposed to each other with the upper and lower electrodes **41** and **42** being inside. The glass substrate **52** and the silicon substrate **55** are positionally aligned so as to oppose the lower electrodes **42** to the counter electrodes **51**. The silicon substrate **55** and the glass substrate **52** are sealed together at a periphery thereof, and then a liquid crystal is filled therebetween to form the liquid crystal layer **53**.

In the first example, the liquid crystal layer **53** is formed of an acrylic polymeric nematic liquid crystal (Ti = 106°C, degree of polymerization: 150) having p-cyanobiphenyl as a mesogen radical. The polymeric nematic liquid crystal is gradually cooled from an isotropic phase while being applied with an AC voltage of 100 V and 500 Hz. Thus, the liquid crystal is put into a homeotropic structure. Then, the recording section **34** produced in this manner is diced and bonded, and then accommodated into a package.

The principle of writing and reading data in the non-volatile memory cell according to the first example will be described, hereinafter.

In the first example, a phase transition or a change in the state of the liquid crystal caused by a thermal change thereof is utilized for writing data, and a change in the dielectric constant of the liquid crystal accompanying the change in the state is utilized for reading data. In a liquid crystal such as an acrylic polymeric nematic liquid crystal having p-cyanobiphenyl as a mesogen radical or a polysiloxane polymeric smectic liquid crystal, the phase is transited into an isotropic phase by heating. By rapidly cooling thereafter, the mono-domain structure of the liquid crystal is changed into a poly-domain structure. Since the poly-domain structure can be kept for a long duration of time at room temperature, data written utilizing the above structural change can be kept for a long duration of time. When being heated in the poly-domain structure and then gradually cooled, the poly-domain structure of the liquid crystal is changed into a mono-domain structure. Since the dielectric constant of the liquid crystal is different in a mono-domain structure and in a poly-domain structure, the structure of the liquid crystal is detected by measuring the dielectric constant. Thus, the data recorded in the liquid crystal can be read out electrically. By this principle, data writing and reading is effected.

The liquid crystal is transparent in a mono-domain structure while being opalescent in a poly-domain structure due to diffusion of light. Utilizing this feature, data can also be read out optically by emitting light such as a laser beam to the recording section **34** and then detecting the light reflected by each memory cell **43.**

Instead of the acrylic polymeric nematic liquid crystal, any other type of liquid crystal may be used. The usable liquid crystals include a polymeric liquid crystal having a cholesteric liquid crystal as a mesogen radical, a polymeric liquid crystal having a smectic liquid crystal as a mesogen radical, a polymeric liquid crystal having a nematic liquid crystal as a mesogen radical, a liquid crystal having two of the above three types of liquid crystal components in one molecule, a mixture of these three types of polymeric liquid crystals, and a mixture of an identical type of liquid crystals having different mesogen radicals.

Hereinafter, a practical operation for writing, erasing and reading data in the non-volatile memory device according to the first example will be described.

[Writing and erasing data]

Data sent from an external device is recorded in a buffer memory in the input/output signal controlling section **31**, and is written into the recording section **34** after data processing. Writing is performed by applying a pulse voltage to a portion of the heat generating layer **44** through a certain pair of upper and lower electrodes **41** and **42** and thus heating the memory cell **43** of the liquid crystal layer **53**, the memory cell **43** corresponding to the above portion of the

heat generating layer **44**. The liquid crystal in the above memory cell **43** is heated by the application of the pulse voltage, and is rapidly cooled when the application stops. By such rapid cooling, the mono-domain structure of the liquid crystal of the memory cell **43** is changed into a poly-domain structure. In this state, data is written in the memory cell **43**. Other memory cells **43** to which no data is to be written are not heated, thereby the mono-domain structure is retained. When the memory cell **43** having the data written is heated again and then pulse voltage applied to the heat generating layer **44** is gradually lowered thus to gradually cool the memory cell **43**, the poly-domain structure of the liquid crystal of the memory cell **43** is changed into a mono-domain structure. In this state, the data is erased. To which memory cell **43** the data is to be written is freely selected, thereby realizing random access.

Figure **5** shows nine memory cells formed of three lower electrodes **D1** through **D3** and three upper electrodes **U1** through **U3**. For example, in order to write data into the memory cell **M11**, a pulse voltage of +V1 is applied to the lower electrode **D1** by a lower electrode driving circuit of the driving circuit section **33** and a pulse voltage of -V1 is applied to the upper electrode **U1** by an upper electrode driving circuit of the driving circuit section **33**. Thus, the memory cell **M11** is heated with a pulse voltage of 2V1. In this case, since the voltages as shown by a solid line **a** in Figure **6** are applied to both of the upper electrode **U1** and the lower electrode **D1**, the liquid crystal in the memory cell **M11** is once heated and then is rapidly cooled. Thus, the liquid crystal in the memory cell **43** is put into a poly-domain structure, in which state, the data is written. Pulse voltages are sequentially applied to the upper electrodes **41** and the lower electrodes **42** corresponding to the memory cells **43** to which data is to be written in this manner. Thus, data is written in the non-volatile memory device entirely.

In order to erase the data written in the memory cell **M11**, a pulse voltage which is gradually lowered as is shown by a dashed line **b** in Figure **6** is applied to the upper electrode **U1** and the lower electrode **D1**. By the application of such a pulse voltage, the liquid crystal in the memory cell **M11** is gradually cooled and is put into a mono-domain structure. Thus, the data written in the memory cell **M11** is erased. In order to erase all the data in a short period of time, pulse voltages which are gradually lowered are applied to all the upper electrodes **41** and all the lower electrodes **42**.

[Reading data]

Since the dielectric constant is different in a mono-domain structure and a poly-domain structure as is mentioned above, data can be read out by measuring the difference in electric capacitance between a mono-domain structure and a poly-domain structure. Namely, an AC voltage is applied between the upper electrodes **41** and the counter electrodes **51** to measure the electric capacitances of the memory cells **43** in the liquid crystal layer **53**. Thus, the data is read out. Practically, as is shown in Figure **5**, signals **X1**, **X2** and **X3** each having a specified waveform are respectively applied to the upper electrodes **U1**, **U2** and **U3**; and signals **Y1**, **Y2** and **Y3** each having a specified waveform are respectively applied to the lower electrodes **D1**, **D2** and **D3**, in the state where the counter electrodes **51** are applied with a voltage. Signals **x1**, **x2** and **x3** which are outputted to the upper electrodes **U1**, **U2** and **U3** are amplified by an amplifier, and thus a change in impedance in each signal is detected by an impedance change detecting circuit. In this way, a change in the dielectric constant of the liquid crystal in each memory cell **43** is detected. The signals **x1**, **x2** and **x3** will be referred to as the output signals, hereinafter.

In order to avoid crosstalk, the signals **X1** through **X3** and **Y1** through **Y3** are controlled in terms of waveform and level. Figure **7** shows waveforms of the signals for reading data from the memory cells **M12**, **M22** and **M32** corresponding to the lower electrode **D2**, as an example. The signal **Y2** is applied to the lower electrode **D2** at a constant level, and the signals **X1** through **X3**, **Y1** and **Y3** applied to the upper electrodes **U1** through **U3** and the lower electrodes **D1** and **D3** are square waveform signals synchronized with one another. The output signal **x2** at the upper electrode **U2** has a smaller amplitude than the other output signals **x1** and **x3**. From this, it is detected that data is written in the memory cell **M22** corresponding to the intersection of the upper electrode **U2** and the lower electrode **D2**.

In the case when the liquid crystal material has a large anisotropy, the above detection is performed with a sufficient accuracy by applying square waveform signals having a high frequency for measuring the impedance. The square waveform signals having a high frequency allow for high speed reading. Instead of the square waveform, the signals may have a triangular, a sawtooth-like, a sinusoidal, or a pulse waveform.

In the case when square waveform signals having a relatively low frequency are applied, a sufficient accuracy may not be obtained. In order to avoid this inconvenience, a square waveform signal superimposed with a high frequency component (Figure **8**) may be applied to upper electrodes **U1** through **U3** and the lower electrodes **D1** and **D3**. In this case also, the signal **Y2** is applied to the lower electrode **D2** at a constant level. For reading data, the high frequency components of the output signals **x1** through **x3** are used instead of the square waveforms thereof. Practically, the data is read out by detecting the difference in amplitude between the high frequency component of the output signal **x2** and those of the other output signals **x1** and **x3**.

A square waveform signal superimposed with a high frequency component can also be used in the case when the dependency of the liquid crystal material on the frequency is changed. For example, in the case when the material

which is changed in dielectric constant, resistivity and other properties at a certain frequency in accordance with a change in the alignment state is used, the component of the certain frequency is superimposed on the square waveform signal. Thus, a change in the alignment state is accurately detected to guarantee accurate reading of the data.

In Figure **9**, signals each superimposed with a high frequency component are applied to all the upper electrodes and all the lower electrodes except for the lower electrode **D2** corresponding to the memory cell **M12** from which data is to be read out. To the lower electrode **D2**, a square waveform signal without a high frequency component is applied. Thus, the output signals **x1** through **x3** are formed of only high frequency components, thereby simplifying the construction of the impedance change detecting circuit and the construction of a signal generating circuit. It is also possible to apply a square waveform signal to the lower electrode **D2** from which data is to be read out and apply signals having reverse square waveforms thereto to the other electrodes **U1** through **U3**, **D1** and **D3** (Figure **10**). In this case, a difference in amplitude between the output signal **x2** and the other output signals **x1** and **x3** is enlarged, thereby guaranteeing more accurate reading of the data.

The waveform of the output signals **x1** through **x3** significantly differs depending on the properties of the liquid crystal material. Such a difference is not a problem as long as the data recorded by the change in the alignment state is detected as a difference in impedance. For example, when a liquid crystal material which changes in conductivity in accordance with a change in the alignment state is used, the output signals **x1** through **x3** each having a square waveform shown in Figure **11** are applied.

No voltage level is indicated in Figures **7** through **11**. In the case when a DC component of a voltage has an adverse affect on the liquid crystal, an appropriate voltage is selected so as to avoid the application of the DC component on the liquid crystal. Application of only a positive voltage or only a negative voltage is realized by selecting an appropriate voltage. The voltage to be applied for reading data is generally set to a low level, for example, 0 to 30 V in order to avoid any change of a fixed alignment state of the liquid crystal. Practically, a voltage of 10 V or lower is desirable for stable recording.

As is mentioned above, the liquid crystal is transparent in a mono-domain structure, but is opalescent in a poly-domain structure due to diffusion of light. Accordingly, data can also be read out by emitting light such as a laser beam to the recording section **34** and then detecting the light reflected by each memory cell **43**.

Figure **12** is a schematic view of an optical reading apparatus. A laser beam emitted from a laser **71** is emitted to the recording section **34** of the non-volatile memory device according to the first example through a movable mirror **72** and a polygon mirror **73**. The movable mirror **72** for receiving the laser beam emitted from the laser **71** is rotated in such a direction as to move the laser beam to scan the recording section **34** in the direction of **N**. The polygon mirror **73** for receiving the laser beam reflected by the movable mirror **72** is rotated in such a direction as to move the laser beam to scan the recording section **34** in the direction of **M**. By rotating the movable mirror **72** and the polygon mirror **73** in synchronization, an entire surface of the recording section **34** is scanned by the laser beam.

The laser beam emitted to the recording section **34** is reflected in different directions depending on the alignment state of the liquid crystal in each memory cell of the recording section **34**. When the liquid crystal is opalescent in a poly-domain structure, the laser beam is diffused. When the liquid crystal is transparent in a mono-domain structure, the laser beam is transmitted through the liquid crystal layer **53** and is reflected by the surface of the silicon substrate **55**. A photosensor **74** provided as opposed to the recording section **34** does not receive the laser beam reflected by the silicon substrate **55** but receives only the laser beam diffused by the opalescent liquid crystal. When the laser beam is received by the photosensor **74**, by which memory cell the laser beam is diffused is specified and thus the data written in this memory cell **43** is read out.

As the laser **71**, a semiconductor laser which is generally used for reading optical memory or a laser having a low optical output is used so that the temperature of the liquid crystal will not be increased by the emission of the laser beam and so that a phase transition will not occur in accompaniment with the increase of the temperature.

The circuit sections **31** through **33** provided in a periphery of the non-volatile memory device are not limited to ICs, but other circuits or other elements may be used as long as they can be mounted on the single crystalline silicon substrate **55**. However, when the single crystalline silicon substrate **55** is used for the recording section **34**, the use of ICs is advantageous in that mounting is easy and the size of the memory cell is reduced.

In the non-volatile memory device according to the first example, data writing to and data reading from a memory medium are performed by static electric control. Such an operation eliminates a rotating mechanism or a moving mechanism which are required for an optical disc or a magnetic disc. Accordingly, the construction of the memory device is simplified to reduce the size thereof, and the production cost is lowered. Moreover, since complicated components such as a laser pickup or a head and precise structures are not necessary, it does not occur that the memory device is defected by vibration, impact or dust. As a result, the stability of keeping data is significantly improved.

The non-volatile memory device, which has a simpler construction than an IC non-volatile memory device, is easy to produce. Further, by applying the fine patterning technology used for ICs, the memory cells can be more microscopic. Accordingly, a high density, high capacity non-volatile memory device can be produced. Data reading can be performed not only electrically but also optically.

Example 2

A non-volatile memory device according to a second example of the present invention has an identical construction with that of the first example except for the material of the liquid crystal layer **53**. According to the second example, the liquid crystal layer **53** is formed of a ferroelectric polymeric liquid crystal having a ferroelectric liquid crystal introduced into a side chain. Such a ferroelectric polymeric liquid crystal includes, for example, a biphenyl ferroelectric liquid crystal as a mesogen radical as shown by Structural Formula **1**.

(Structural Formula 1)

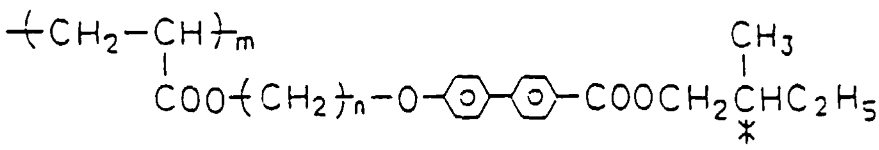

A ferroelectric polymeric liquid crystal having a ferroelectric liquid crystal introduced into a side chain is obtained by introducing a side chain formed of a mesogen radical added with a chiral structure at an end thereof to a polymeric main chain. In the case when an appropriate ferroelectric liquid crystal material is employed for the side chain and an appropriate spacer is put between the side chain and the polymeric main chain, the ferroelectric liquid crystal in the side chain shows a behavior similar to that of a low molecular ferroelectric liquid crystal, namely, expresses ferroelectricity.

The ferroelectric liquid crystal is bistable and is known for a high speed response. Accordingly, the ferroelectric polymeric liquid crystal including the ferroelectric liquid crystal also has a high speed response. The above-mentioned features of the ferroelectric polymeric liquid crystal are explicitly described in "S. Uchida, K. Morita, K. Miyoshi, K. Hashimoto, K. Kawasaki, Mol. Cryst. Liq. Cryst. 1988, 155, 93", "T. Kitazume, T. Ohnogi, K. Ito, J. Am. Chem. Soc, 1990, 112, 6608", "T. Sekiya, K. Kawasaki, Kohbunshi (Polymer), 1991, 40, July, 454", and "T. Kitazume, Kinohzairyo (Functional Material), 1990, Sept., 43".

Figure **13** shows a DSC (differential scanning calorimetry) curve of the ferroelectric polymeric liquid crystal having the biphenyl ferroelectric liquid crystal shown in Structural Formula **1**. As is apparent from Figure **13**, the phase of this ferroelectric liquid crystal is transited from a glass phase, to a chiral SmI (or chiral SmF) phase, to a chiral SmC phase, to an SmA phase, and to an isotropic phase. In a low temperature range corresponding to room temperature, the liquid crystal is in a glass phase. As the temperature is raised, the phase of the liquid crystal is transited to a chiral SmI phase and then to a chiral SmC phase. The chiral SmC phase is kept for a long duration of time. For writing data in a certain memory cell **43**, the temperature of this memory cell **43** is raised to put the liquid crystal therein into a chiral SmC phase, and an electric field is applied to the liquid crystal in the memory cell **43**. Then, the alignment state thereof is changed. Thus, the data is written in the above memory cell **43**.

In order to raise the temperature of the ferroelectric polymeric liquid crystal, a voltage is applied between the upper electrode **41** and the lower electrode **42**, thereby generating heat in a portion of the heat generating layer **44** corresponding to the memory cell **43** to which data is to be written. When the ferroelectric polymeric liquid crystal in the memory cell **43** is put into a chiral SmC phase, a voltage of, for example, 15 V is applied between the counter electrode **51** and the upper electrode **41** so as to apply an electric field to the memory cell **43**, thereby changing the alignment state of the ferroelectric polymeric liquid crystal. Thus, the alignment state of the liquid crystal applied with the electric field differs from that of the remaining liquid crystal applied with no electric field. Utilizing the difference in the alignment state, "ON" and "OFF", namely, "1" and "0" are written. Data writing is performed by sequentially heating the intersections of the upper electrodes **41** and the lower electrodes **42** and then applying a voltage between the counter electrodes **51** and the upper electrodes **41**, thereby applying an electric field to the liquid crystal in memory cell **43.** Accordingly, data writing is performed with a higher efficiency than the case when an electric field is applied to each memory cell to which data is to be written. Depending on the liquid crystal material, the alignment state can be changed by applying a magnetic field instead of an electric field.

After the data is written, the voltage application between the counter electrodes **51** and the upper electrodes **41** is stopped to rapidly cool the ferroelectric polymeric liquid crystal, thereby transiting the phase thereof to a glass phase. Thus, the alignment state of the liquid crystal is fixed. Since this glass phase is kept for a long duration of time, the data written in the liquid crystal is kept for a long duration of time.

The data is read out by detecting a difference in dielectric constant made by the change in the alignment state. The dielectric constant is different depending on the alignment state of the ferroelectric polymeric liquid crystal.

By electrically detecting the difference, the data is read out. Owing to a high dielectric constant of the ferroelectric polymeric liquid crystal, a large value can be detected. In other words, reading can be done with a high S/N ratio, thereby improving reading accuracy.

Data can also be read out by detecting a difference in the directions of spontaneous polarization made by a change in the alignment state of the ferroelectric polymeric liquid crystal. The spontaneous polarization supplies a voltage between the upper electrode **41** and the counter electrode **51**. Since the sign of such a voltage is inverted by a change in the alignment state, the data can be detected by electrically measuring the voltage. Owing to a high degree of spontaneous polarization of the ferroelectric polymeric liquid crystal, a large value can be detected. In other words, reading can be done with a high S/N ratio, thereby improving reading accuracy.

Figure **14** shows the dependency of the response time on the temperature of the ferroelectric polymeric liquid crystal. The response time suddenly shortens when the phase is transited into a chiral SmC phase. This fact indicates that data writing in the state where the ferroelectric polymeric liquid crystal is raised in temperature to be in a chiral SmC phase is performed at a high speed owing to the short response time. After the data writing is finished, the temperature of the ferroelectric polymeric liquid crystal is lowered.

In the case when the data writing is performed at a high speed, the amount of heat transmitted from the memory cell **43** to which data is to be written to the memory cell **43** to which data is not to be written during the data writing is significantly reduced. Accordingly, thermal adverse affect such as thermal crosstalk is reliably prevented, thus improving writing accuracy.

The ferroelectric polymeric liquid crystal is not limited to the one shown in Structural Formula **1** but may be formed of a fluorine ferroelectric polymeric liquid crystal shown in Structural Formula **2**.

(Structural Formula 2)

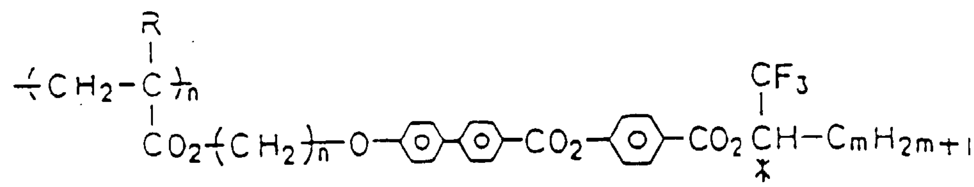

In the second example, the ferroelectric polymeric liquid crystal is raised in temperature to be in a chiral SmC phase for data writing. It is also possible to raise the ferroelectric polymeric liquid crystal in temperature to be in an isotropic phase (Figure **13**) and then apply a voltage to the liquid crystal for data writing.

In the non-volatile memory device according to the second example, a ferroelectric polymeric liquid crystal is used as a memory medium. Owing to the features of the ferroelectric polymeric liquid crystal, data writing can be performed at a high speed, thermal crosstalk is reliably prevented, and data reading is performed easily and highly accurately.

<u>Example 3</u>

In a third example according to the present invention, the liquid crystal layer **53** is formed of a composite of a polymer and a liquid crystal compound. Such a composite is prepared by mixing 2-ethyl-hexylacrylate (monomer), urethane acrylate oligomer, and a cyanobiphenyl type liquid crystal mixture in a polymerization ratio of 12:18:70 and then uniformly mixing the resultant mixture and a photopolymerization initiator. As the liquid crystal mixture, for example, a material mainly including 4-decyl-hexanoylbiphenyl is used. The resultant composite is filled between the silicon substrate **55** and the glass substrate **52**. By emitting ultraviolet rays to this composite, a polymeric phase and a liquid crystal phase are separated from each other to form a PDLC (polymer dispersed liquid crystal).

In the third example, an acrylic polymer is used as the material for forming a polymeric phase, other polymeric materials such as PMMA (poly methyl metacrylate) may also be used. Instead of a cyanobiphenyl type liquid crystal mixture used as the liquid crystal material in the third example, any other material may also be used as long as the material forms a PDLC. As the liquid crystal materials, those mentioned in "A. Sasaki, Ekisho Electronics no Kiso to Ohyo (Basics and Applications of Liquid Crystal - Electronics), published by Ohmu-sha" are used. Instead of emitting ultraviolet rays to the composite filled between the substrates, any other method may be used. The usable methods include a method of curing the composite filled between the substrates by heating, and a method of dissolving the composite in a solvent and removing the solvent after filling the composite between the substrates.

In the PDLC containing the cyanobiphenyl type liquid crystal mixture, molecules are aligned when being applied with an electric field. When the liquid crystal mixture is heated to a temperature at which the nematic - isotropic

phase transition occurs or higher and then cooled, the molecules are put into a isotropic phase. Since the isotropic phase is maintained at room temperature for a long duration of time, data is kept for a long duration of time. The dielectric constant of the liquid crystal is different in an aligned phase and an isotropic phase, the data is read out by detecting a change in impedance accompanying a change in the dielectric constant. Since the liquid crystal is opalescent in an isotropic phase while being transparent in an aligned phase, the data can also be detected optically as is mentioned above.

Accordingly, in the case when a composite of a polymer and a liquid crystal compound is used, an alignment film is not necessary. Therefore, there is no adverse effect of static electricity generated by the formation of the alignment film, thereby guaranteeing stable data writing.

Example 4

In a fourth example according to the present invention, the liquid crystal layer **53** is formed of a conductive polymeric liquid crystal. The conductive polymeric liquid crystal used as the liquid crystal includes a charge-transfer complex as a conductance supplying radical **B**, an ester liquid crystal as a mesogen radical **A**, and an acrylic main chain. The charge-transfer complex has phenanthrene as an electron donor and iodine as an electron acceptor. Such a conductive polymeric liquid crystal is filled between the silicon substrate **55** and the glass substrate **52**. The conductive polymeric liquid crystal is gradually cooled from an isotropic phase while applying an AC voltage of 100 V and 500 Hz. Thus, the liquid crystal is put into a homogeneous structure. The recording section **34** produced in this manner is diced and bonded, and then accommodated into a package.

In the case when such a conductive polymeric liquid crystal is used as the liquid crystal material, a phase transition or other change in the state of the liquid crystal caused by a thermal change thereof is utilized for writing data, and a change in the dielectric constant accompanying the change in the state is utilized for reading data.

As is shown in Figure **15**, a conductive polymeric liquid crystal includes a polymeric main chain **P**, a mesogen radical **A** (liquid crystal), a conductance supplying radical **B** and spacers **S**. The mesogen radical **A** is connected to the polymeric main chain **P** through the spacer **S**. The conductance supplying radical **B** is connected to the mesogen radical **A** through another spacer **S**.

The polymeric main chain **P** is formed of an acrylic polymer, a silicon polymer, a meta acrylic polymer or a compound thereof. The mesogen radical **A** fixes an end of the conductance supplying radical **B**, and further influences the temperature at which a phase transition occurs and the response speed. The mesogen radical **A** is formed of a liquid crystal compound including azomethyl, azoxy, biphenyl-type liquid crystals and the like. The mesogen radicals **A** are aligned when being applied with an electric field while being cooled from an isotropic phase, thereby forcibly arranging the conductance supplying radicals **B** in order. The conductance supplying radical **B** is a charge-transfer complex, namely, has conductance, only when being arranged in order, in the direction of the arrangement. This feature is used for data writing. The spacers **S**, which are formed of methylene chains or the like, determine the degree of freedom of the mesogen radical **A**. The length of the molecule of the spacer **S** influences important properties of the memory device such as the response speed. Accordingly, it is important to employ a conductive liquid crystal having such molecules as facilitate the alignment of the mesogen radicals **A** and the arrangement of the conductance supplying radicals **B**. The spacers **S** may be eliminated.

Figure **16A** schematically shows a conductive polymeric liquid crystal in the state where the mesogen radicals **A** are aligned and the conductance supplying radicals **B** are arranged in order. The alignment of the mesogen radicals **A** forcibly arranges the conductance supplying radicals **B** in order. Accordingly, the current flows in the direction of the arrows (or in the opposite direction) through the adjacent conductance supplying radicals **B**, thereby turning the liquid crystal conductive.

Figure **16B** schematically shows a conductive polymeric liquid crystal in the state where the mesogen radicals **A** are not aligned and the conductance supplying radicals **B** are not arranged in order. Accordingly, the liquid crystal does not turned conductive and has a high electrical resistance.

Such a conductive polymeric liquid crystal is filled between the silicon substrate **55** and the glass substrate **52**. The liquid crystal is switched between the conductive state and the highly resistive state by controlling the current flowing for heating the liquid crystal between the upper electrode **41** and the lower electrode **42** and the voltage applied for writing data between the upper electrode **41** and the counter electrode **51**. Thus, data writing and erasing can be performed.

A principle of writing and reading will be described with reference to Figures **17**, **18A** and **18B**. The conductive polymeric liquid crystal is heated to be in an isotropic phase, is applied with a voltage, and then is rapidly cooled. Thus, the mesogen radicals **A** are aligned. The conductance supplying radicals **B** are forcibly arranged in order by the alignment of the mesogen radicals **A**. Since electric charges can move through the adjacent conductance supplying radicals **B**, the liquid crystal turns conductive as is shown in Figure **17**. In the case when a liquid crystal having a negative dielectric anisotropy is used as the mesogen radicals **A**, the mesogen radicals **A** are in the homogeneous structure.

The conductance supplying radicals **B** are forcibly put into a homogeneous structure by the mesogen radicals **A**. When the conductance supplying radicals **B** are arranged in order, the liquid crystal is conductive in a direction of the arrangement. In Figure **17**, the liquid crystal is conductive between the counter electrodes **51** and the upper electrodes **41**.

On the other hand, when the conductive polymeric liquid crystal is rapidly cooled from an isotropic phase without applying a voltage, the mesogen radicals **A** are not aligned, and thus the conductance supplying radicals **B** are not arranged in order. Accordingly, the liquid crystal has a high electrical resistance with no conductance as is shown in Figures **18A** and **18B**. In Figure **18A,** the polymeric main chains **P**, the mesogen radicals **A**, and the conductance supplying radicals **B** are all in disorder. In Figure **18B**, the polymeric main chains **P** are arranged in order, but the mesogen radicals **A** are not aligned and thus the conductance supplying radicals **B** are not arranged in order. Accordingly, the liquid crystal does not turn conductive. In Figures **18A** and **18B**, the liquid crystal has a high electrical resistance between the counter electrodes **51** and the upper electrodes **41**. Whether the liquid crystal is put into the state of Figure **18A** or Figure **18B** depends on various elements such as heating conditions, alignment conditions by the alignment films **56** and **56'**, and the type of the conductive polymeric liquid crystal. It is desirable to select such elements as realize the state of Figure **18B** in order to obtain a high speed response.

The conductance and the electrical resistance of the liquid crystal are judged by applying an AC or a DC voltage between the upper electrode **41** and the counter electrode **51** to measure the impedance or the conductivity of the liquid crystal.

A practical operation for writing and reading data of the memory device using a conductive polymeric liquid crystal as the memory medium will be described.

[Data writing and erasing]

Data writing is performed in the following manner. A voltage is applied between the upper electrode **41** and the lower electrode **42** as a heating voltage so that a specified voltage is applied to a portion of the heat generating layer **44** corresponding to the memory cell **43** to which data is to be written. Thus, the portion of the heat generating layer **44** is heated, thereby heating the liquid crystal in the memory cell **43**. When the liquid crystal in the memory cell **43** is put into an isotropic phase, a voltage is applied between the upper electrode **41** and the lower electrode **42** as a writing voltage while the application of the heating voltage is stopped, thereby rapidly cooling the liquid crystal. Thus, the liquid crystal turns conductive. The specific resistance of the liquid crystal is: $\rho = 10^6$ to $10^8$ $\Omega$·cm.

On the other hand, when the liquid crystal which is in an isotropic phase is rapidly cooled without applying a writing voltage, the liquid crystal obtains a high electrical resistance. The specific resistance of the liquid crystal at this point is: $\rho = 10^{12}$ to $10^{13}$ $\Omega$·cm.

The conductive state and the highly resistive state can be switched at any time. Either state may be recorded as "ON". Since the memory cell **43** to which data is to be written can freely be selected, random access is possible.

[Data reading]

An AC or an DC voltage is applied between the upper electrode **41** and the counter electrode **51**, thereby measuring the conductivity or the impedance of the liquid crystal in the memory cell **43** from which data is to be read out. The specific resistance of the liquid crystal is significantly different between the case when the mesogen radicals **A** are not aligned and the conductance supplying radicals **B** are not arranged in order and the case when the mesogen radicals **A** are aligned but the conductance supplying radicals **B** are not arranged in order. Accordingly, data can be read out by detecting the difference in the conductivity.

As the conductive polymeric liquid crystal, the ones disclosed in Japanese Laid-Open Patent Publication No. 59-59705 may be used. The conductive polymeric liquid crystal is not limited to one having a charge-transfer complex as the conductance supplying radical **B**, but may be any other compound as long as the compound has a conductivity which is changed in accordance with a change in the alignment state or a phase transition. For example, a polymer using a conjugate system of polyacetylene type main chains and the like, or an organic conductive polymer including a composite of such a polymer and a metal may be employed as the conductive polymeric liquid crystal.

The use of such a conductive polymeric liquid crystal as an alignment film further enlarges the ON/OFF ratio of a read-out signal, thereby enlarging the S/N ratio of the read-out signal. As a result, the reading accuracy is improved. The enlargement of the ON/OFF ratio also offers an advantage that the amplification factor of an amplifier for amplifying the read-out signal can be low.

In order to explain why the use of a conductive polymeric liquid crystal as an alignment film enlarges the ON/OFF ratio (actually, OFF/ON ratio) of the read-out signal in correlation with the ON/OFF state of the memory cell **43** will be described, with reference to Figure **19**.

For data reading, an **AC** voltage is applied as a reading voltage between the counter electrode **51** and the upper electrode **41** from an **AC** power source **100.** In Figure **19,** $C_1$ denotes the capacitance of the alignment film **56'**;

$C_2$ denotes the capacitance of the liquid crystal; and $C_3$ denotes the capacitance of the alignment film **56**. $R_1$ denotes the resistance of the alignment film **56'**; $R_2$ denotes the resistance of the liquid crystal; and $R_3$ denotes the resistance of the alignment film **56**.

Where the area of the memory cell **43** is:

$$S = 2\ \mu m \times 2\ \mu m = 4 \times 10^{-12}\ m^2;$$

the thickness of each alignment film **56** or **56'** formed of polyimide (dielectrics) is:

$$t = 0.02\ \mu m = 2 \times 10^{-8}\ m;$$

the thickness of the liquid crystal layer **53** is:

$$L = 1.0\ \mu m = 1 \times 10^{-6}\ m;$$

the specific dielectric constant of polyimide is:

$$\varepsilon_S = 3.3;$$

the specific dielectric constant of the liquid crystal is:

$$\varepsilon_S = 5.0;$$

the specific resistance of polyimide is:

$$\rho = 10^{16}\ \Omega\cdot cm;$$

the specific resistance of the liquid crystal at OFF (in the non-conductive state) is:

$$\rho = 10^{12}\ \Omega\cdot cm;$$

and

the specific resistance of the liquid crystal at ON (in the conductive state) is:

$$\rho = 10^{6}\ \Omega\cdot cm;$$

the capacitance $C_i$ (**i** = 1, 2, 3) is expressed by Formula (1):

$$C_i = \varepsilon_0 \cdot \varepsilon_s \cdot S/t \qquad (1)$$

where the specific dielectric constant in vacuum is:

$$\varepsilon_0 = 8.9 \times 10^{-12}$$

By substituting the above values into Formula (1),

$$C_1 = C_3 = 5.9 \times 10^{-15} [F],$$

and

$$C_2 = 1.8 \times 10^{-16} [F].$$

Capacitive reactances $\mathbf{R_{C1}}$, $\mathbf{R_{C2}}$ and $\mathbf{R_{C3}}$ with respect to the capacitances $\mathbf{C_1}$, $\mathbf{C_2}$ and $\mathbf{C_3}$ are expressed by Formula (2):

$$\left.\begin{aligned} R_{C1} &= 1/(2\pi f C_1) \\ R_{C2} &= 1/(2\pi f C_2) \\ R_{C3} &= 1/(2\pi f C_3) \end{aligned}\right\} \ldots \quad (2)$$

where f is the frequency of the reading voltage applied between the counter electrode **51** and the upper electrode **41** from the AC power source **100**. In the fourth example, an AC voltage of 60 Hz is used as the reading voltage.
By substituting the values of $\mathbf{C_1}$, $\mathbf{C_2}$ and $\mathbf{C_3}$ into Formula (2),
the capacitive reactances $\mathbf{R_{C1}} = \mathbf{R_{C3}} = 4.50 \times 10^{11}\ \Omega$, and $\mathbf{R_{C2}} = 1.5 \times 10^{13}\ \Omega$.
The resistance $\mathbf{R_i}$ is expressed by Formula (3):

$$R_i = \rho \cdot L/S \quad (3)$$

By substituting the above values into Formula (3),

$$R_1 = R_3 = 5.0 \times 10^{17}\ \Omega.$$

The values of $\mathbf{R_2}$ at OFF and ON are:

$$R_{OFF2} = 2.5 \times 10^{15}\ \Omega,$$

and

$$R_{ON2} = 2.5 \times 10^{9}\ \Omega.$$

From the above results, the resistance $\mathbf{R_{OFF}}$ obtained when the memory cell **43** is OFF and the resistance $\mathbf{R_{ON}}$ obtained when the memory cell **43** is ON are expressed by Formulas (4) and (5):

$$R_{OFF} = R_1 \cdot R_{C1}/(R_1 + R_{C1}) + R_{OFF2} \cdot R_{C2}/(R_{OFF2} + R_{C2})$$
$$+ R_3 \cdot R_{C3}/(R_3 + R_{C3}) = 1.55 \times 10^{13}\ \Omega \quad (4)$$

$$R_{ON} = R_1 \cdot R_{C1}/(R_1 + R_{C1}) + R_{ON2} \cdot R_{C2}/(R_{ON2} + R_{C2})$$
$$+ R_3 \cdot R_{C3}/(R_3 + R_{C3}) = 0.9 \times 10^{12}\ \Omega \quad (5)$$

From Formulas (4) and (5), the ratio of the resistances (1/conductivity ratio) in correlation with the OFF/ON state of the memory cell **43** is expressed by Formula (6):

$$R_{OFF}/R_{ON} = 17 \quad (6)$$

As is apparent from Formula (6), since the resistance ratio in correlation with the OFF/ON state of the memory cell **43** can be enlarged according to the fourth example, the OFF/ON ratio of the read-out signal can be large. As a result, the reading accuracy can be improved.

Hereinafter, the OFF/ON ratio of the read-out signal in the case when a conductive liquid crystal is used as the alignment films **56** and **56'** will be described.

Conductive polyimide including a small amount of carbon mixed therein is used to form the alignment films **56** and **56'** each having a specific resistance $\rho = 10^3$ Ωcm. From Formula (3), $\mathbf{R_1} = \mathbf{R_3} = 5 \times 10^4$ Ω. From Formulas (4) and (5),

$$R_{OFF} = 1.5 \times 10^{13}\ \Omega,$$

and

$$R_{ON} = 2.5 \times 10^{9}\ \Omega.$$

Accordingly, the resistance ratio is: $\mathbf{R_{OFF}}/\mathbf{R_{ON}} = 6 \times 10^3$. As apparent from this value, the OFF/ON ratio of the read-out signal can be much larger than the ON/OFF ratio which is obtained in the case when a non-conductive liquid crystal is used. Therefore, the reading accuracy can be improved.

As is mentioned above, the non-volatile memory device according to the fourth example, the ON/OFF ratio of a read-out signal is large, resulting in an improvement of writing accuracy.

Various modifications will be apparent to the person skilled in the art. Accordingly, the scope of the invention is not limited to the preferred embodiments described above but is defined by the appended claims.

## Claims

**1.** A non-volatile memory device, comprising:

a first substrate (52) and a second substrate (55) disposed parallel with each other with a gap therebetween;
a memory medium (53) provided between the first and second substrates and formed of a material selected from the group consisting of a liquid crystal compound and a composite including a liquid crystal component in one molecule;
a counter electrode (51) provided on a surface of the first substrate (52), the surface facing the memory medium;
heating means provided on the second substrate and including a plurality of strip-like lower electrodes (42) insulated from one another and arranged in parallel with one another, a plurality of strip-like upper electrodes (41) arranged perpendicular to the lower electrodes, and a heat generating layer (44) sandwiched between the upper and the lower electrodes so as to receive current from the upper and the lower electrodes at intersections thereof, the heating means being provided for writing data into the memory medium by heating the memory medium and thus changing a phase of the memory medium; and
reading means for reading the data written into the memory medium;

characterised in that the memory device further comprises an electrically insulating film (54) provided on the lower electrodes (42), the insulating film being provided in regions where the upper electrodes (41) do not overlay the lower electrodes (42); and in that the reading means is adapted to detect electrically a change in a property of the memory medium using the counter electrode and one or more of the upper electrodes.

**2.** A non-volatile memory device according to claim 1, wherein the reading means detects a difference between a dielectric constant of the memory medium in a mono-domain structure and a dielectric constant of the memory medium in a poly-domain structure.

**3.** A non-volatile memory device according to claim 1, wherein the memory medium is formed of a material selected from the group consisting of a polymeric nematic liquid crystal, a polymeric smectic liquid crystal, a polymeric cholesteric liquid crystal, a liquid crystal material including at least two types of liquid crystal components in one molecule, and a mixture of a polymeric nematic liquid crystal, a polymeric smectic liquid crystal and a polymeric cholesteric liquid crystal.

4. A non-volatile memory device according to claim 1, wherein the memory medium is formed of a ferroelectric polymeric liquid crystal.

5. A non-volatile memory device according to claim 4, wherein the reading means detects a difference between dielectric constants of the ferroelectric polymer liquid crystal in different alignment states by use of the counter electrode and the upper electrodes.

6. A non-volatile memory device according to claim 4, wherein the reading means detects a difference between degrees of spontaneous polarization of the ferroelectric polymer liquid crystal in different alignment states by use of the counter electrode and the upper electrodes.

7. A non-volatile memory device according to claim 1, wherein the memory medium is formed of a composite of a polymer and a liquid crystal compound.

8. A non-volatile memory device according to claim 7, wherein the reading means detects a difference between dielectric constants of the liquid crystal compound in different alignment states by use of the counter electrode and the upper electrodes.

9. A non-volatile memory device according to claim 1, wherein the memory medium is formed of a conductive polymer liquid crystal.

10. A non-volatile memory device according to claim 9, wherein the reading means detects a change in conductivity of the conductive polymer liquid crystal by use of the counter electrode and the upper electrodes.

11. A non-volatile memory device according to claim 9, wherein the memory medium is in contact with a conductive alignment film.

12. A non-volatile memory device according to claim 1, wherein the second substrate is a silicon substrate.

13. A non-volatile memory device according to claim 12, wherein the silicon substrate has an insulating film provided on a surface thereof having the lower electrodes.

14. A non-volatile memory device, comprising:

a first substrate (52) and a second substrate (55) disposed parallel with each other with a gap therebetween;
a memory medium (53) provided between the first and second substrates and formed of a material selected from the group consisting of a liquid crystal compound and a composite including a liquid crystal component in one molecule;
a counter electrode (51) provided on a surface of the first substrate (52), the surface facing the memory medium;
heating means provided on the second substrate and including a plurality of strip-like lower electrodes (42) insulated from one another and arranged in parallel with one another, a plurality of strip-like upper electrodes (41) arranged perpendicular to the lower electrodes, and a heat generating layer (44) sandwiched between the upper and the lower electrodes so as to receive current from the upper and the lower electrodes at intersections thereof, the heating means being provided for writing data into the memory medium by heating the memory medium and thus changing a phase of the memory medium; and
reading means for reading the data written into the memory medium optically detecting a phase transition of the memory medium; characterised in that the memory device further comprises an electrically insulating film (54) provided on the lower electrodes (42), the insulating film being provided in regions where the upper electrodes do not overlay the lower electrodes.

15. A non-volatile memory device according to claim 14, wherein the reading means optically detects a non-transparent state and a transparent state of the memory medium.

16. A non-volatile memory device according to claim 14, wherein the memory medium is formed of a material selected from the group consisting of a polymeric nematic liquid crystal, a polymeric smectic liquid crystal, a polymeric cholesteric liquid crystal, a liquid crystal material including at least two types of liquid crystal components in one molecule, and a mixture of a polymeric nematic liquid crystal, a polymeric smectic liquid crystal and a polymeric

cholesteric liquid crystal.

**17.** A non-volatile memory device according to claim 14, wherein the memory medium is formed of a ferroelectric polymeric liquid crystal.

**18.** A non-volatile memory device according to claim 14, wherein the memory medium is formed of a composite of a polymer and a liquid crystal compound.

**19.** A non-volatile memory device according to claim 14, wherein the memory medium is formed of a conductive polymer liquid crystal.

**20.** A non-volatile memory device according to claim 19, wherein the memory medium is in contact with a conductive alignment film.

**21.** A non-volatile memory device according to claim 14, wherein the second substrate is a silicon substrate.

**22.** A non-volatile memory device according to claim 21, wherein the silicon substrate has an insulating film provided on a surface thereof having the lower electrode.

## Patentansprüche

**1.** Nichtflüchtiger Speicher mit:

- einem ersten Substrat (52) und einem zweiten Substrat (55), die parallel zueinander mit einem gegenseitigen Abstand angeordnet sind;
- einem Speichermedium (53), das zwischen dem ersten und zweiten Substrat vorhanden ist und aus einem Material ausgewählt ist, das aus der aus einer Flüssigkristallverbindung und einem Verbundmaterial, das eine Flüssigkristallkomponente in einem Molekül enthält, bestehenden Gruppe ausgewählt ist;
- einer Gegenelektrode (51), die auf derjenigen Oberfläche des ersten Substrats (52) vorhanden ist, die dem Speichermedium zugewandt ist;
- einer Erwärmungseinrichtung, die auf dem zweiten Substrat vorhanden ist, und eine Vielzahl streifenförmiger unterer Elektroden (42), die gegeneinander isoliert sind und parallel zueinander angeordnet sind, eine Vielzahl streifenförmiger oberer Elektroden (41), die rechtwinklig zu den unteren Elektroden angeordnet sind, und eine Wärmeerzeugungsschicht (44) aufweist, die zwischen die oberen und unteren Elektroden eingebettet ist, um an Schnittstellen zwischen den oberen und unteren Elektroden von diesen Strom zu erhalten, wobei die Heizeinrichtung vorhanden ist, um dadurch Daten in das Speichermedium einzuschreiben, dass das Speichermedium erwärmt wird und so seine Phase geändert wird; und
- einer Leseeinrichtung zum Lesen der in das Speichermedium geschriebenen Daten;

**dadurch gekennzeichnet,** dass er ferner einen elektrisch isolierenden Film (54) aufweist, der auf den unteren Elektroden (42) in solchen Bereichen vorhanden ist, in denen die oberen Elektroden (41) nicht über den unteren Elektroden (42) liegen; und die Leseeinrichtung so ausgebildet ist, dass sie elektrisch eine Eigenschaftsänderung des Speichermediums unter Verwendung der Gegenelektrode und einer oberen oder mehrerer oberer Elektroden erfasst.

**2.** Nichtflüchtiger Speicher nach Anspruch 1, bei dem die Leseeinrichtung die Differenz zwischen der Dielektrizitätskonstante des Speichermediums in einer Monodomänenstruktur und der Dielektrizitätskonstante des Speichermediums in einer Polydomänenstruktur erfasst.

**3.** Nichtflüchtiger Speicher nach Anspruch 1, bei dem das Speichermedium aus einem Material besteht, das aus der aus Folgendem bestehenden Gruppe ausgewählt ist: einem nematischen Polymerflüssigkristall, einem smektischen Polymerflüssigkristall, einem cholesterischen Polymerflüssigkristall, einem Flüssigkristallmaterial, das mindestens zwei Flüssigkristallkomponenten in einem Molekül enthält, und einem Gemisch aus einem nematischen Polymerflüssigkristall, einem smektischen Polymerflüssigkristall und einem cholesterischen Polymerflüssigkristall.

**4.** Nichtflüchtiger Speicher nach Anspruch 1, bei dem das Speichermedium aus einem ferroelektrischen Polymerflüssigkristall besteht.

5. Nichtflüchtiger Speicher nach Anspruch 4, bei dem die Leseeinrichtung die Differenz zwischen den Dielektrizitätskonstanten des ferroelektrischen Polymerflüssigkristalls in verschiedenen Ausrichtungszuständen unter Verwendung der Gegenelektrode und der oberen Elektroden erfasst.

6. Nichtflüchtiger Speicher nach Anspruch 4, bei dem die Leseeinrichtung die Differenz zwischen den Ausmaßen spontaner Polarisation des ferroelektrischen Polymerflüssigkristalls in verschiedenen Ausrichtungszuständen unter Verwendung der Gegenelektrode und der oberen Elektroden erfasst.

7. Nichtflüchtiger Speicher nach Anspruch 1, bei dem das Speichermedium aus einem Verbundmaterial aus einem Polymer und einer Flüssigkristallverbindung besteht.

8. Nichtflüchtiger Speicher nach Anspruch 7, bei dem die Leseeinrichtung die Differenz zwischen den Dielektrizitätskonstanten der Flüssigkristallverbindung und verschiedenen Ausrichtungszuständen unter Verwendung der Gegenelektrode und der oberen Elektroden erfasst.

9. Nichtflüchtiger Speicher nach Anspruch 1, bei dem das Speichermedium aus einem leitenden Polymerflüssigkristall besteht.

10. Nichtflüchtiger Speicher nach Anspruch 9, bei dem die Leseeinrichtung die Leitfähigkeitsänderung des leitenden Polymerflüssigkristalls unter Verwendung der Gegenelektrode und der oberen Elektroden erfasst.

11. Nichtflüchtiger Speicher nach Anspruch 9, bei dem das Speichermedium in Kontakt mit einem leitenden Ausrichtungsfilm steht.

12. Nichtflüchtiger Speicher nach Anspruch 1, bei dem das zweite Substrat ein Siliziumsubstrat ist.

13. Nichtflüchtiger Speicher nach Anspruch 12, bei dem das Siliziumsubstrat einen Isolierfilm trägt, der auf seiner Oberfläche mit den unteren Elektroden vorhanden ist.

14. Nichtflüchtiger Speicher mit:

- einem ersten Substrat (52) und einem zweiten Substrat (55), die parallel zueinander mit einem gegenseitigen Abstand angeordnet sind;
- einem Speichermedium (53), das zwischen dem ersten und zweiten Substrat vorhanden ist und aus einem Material ausgewählt ist, das aus der aus einer Flüssigkristallverbindung und einem Verbundmaterial, das eine Flüssigkristallkomponente in einem Molekül enthält, bestehenden Gruppe ausgewählt ist;
- einer Gegenelektrode (51), die auf derjenigen Oberfläche des ersten Substrats (52) vorhanden ist, die dem Speichermedium zugewandt ist;
- einer Erwärmungseinrichtung, die auf dem zweiten Substrat vorhanden ist, und eine Vielzahl streifenförmiger unterer Elektroden (42), die gegeneinander isoliert sind und parallel zueinander angeordnet sind, eine Vielzahl streifenförmiger oberer Elektroden (41), die rechtwinklig zu den unteren Elektroden angeordnet sind, und eine Wärmeerzeugungsschicht (44) aufweist, die zwischen die oberen und unteren Elektroden eingebettet ist, um an Schnittstellen zwischen den oberen und unteren Elektroden von diesen Strom zu erhalten, wobei die Heizeinrichtung vorhanden ist, um dadurch Daten in das Speichermedium einzuschreiben, dass das Speichermedium erwärmt wird und so seine Phase geändert wird; und
- einer Leseeinrichtung zum Lesen der in das Speichermedium geschriebenen Daten durch optisches Erfassen eines Phasenübergangs des Speichermediums;

**dadurch gekennzeichnet,** dass er ferner einen elektrisch isolierenden Film (54) auf der unteren Elektrode (42) in Bereichen aufweist, in denen die oberen Elektroden nicht mit den unteren Elektroden überlappen.

15. Nichtflüchtiger Speicher nach Anspruch 14, bei dem die Leseeinrichtung einen nicht transparenten Zustand und einen transparenten Zustand des Speichermediums optisch erfasst.

16. Nichtflüchtiger Speicher nach Anspruch 14, bei dem das Speichermedium aus einem Material besteht, das aus der aus Folgendem bestehenden Gruppe ausgewählt ist: einem nematischen Polymerflüssigkristall, einem smektischen Polymerflüssigkristall, einem cholesterischen Polymerflüssigkristall, einem Flüssigkristallmaterial, das mindestens zwei Flüssigkristallkomponenten in einem Molekül enthält, und einem Gemisch aus einem nematischen

Polymerflüssigkristall, einem smektischen Polymerflüssigkristall und einem cholesterischen Polymerflüssigkristall.

**17.** Nichtflüchtiger Speicher nach Anspruch 14, bei dem das Speichermedium aus einem ferroelektrischen Polymerflüssigkristall besteht.

**18.** Nichtflüchtiger Speicher nach Anspruch 14, bei dem das Speichermedium aus einem Verbundmaterial aus einem Polymer und einer Flüssigkristallverbindung besteht.

**19.** Nichtflüchtiger Speicher nach Anspruch 14, bei dem das Speichermedium aus einem leitenden Polymerflüssigkristall besteht.

**20.** Nichtflüchtiger Speicher nach Anspruch 19, bei dem das Speichermedium in Kontakt mit einem leitenden Ausrichtungsfilm steht.

**21.** Nichtflüchtiger Speicher nach Anspruch 14, bei dem das zweite Substrat ein Siliziumsubstrat ist.

**22.** Nichtflüchtiger Speicher nach Anspruch 21, bei dem das Siliziumsubstrat einen Isolierfilm trägt, der auf seiner Oberfläche mit der unteren Elektrode vorhanden ist.

**Revendications**

**1.** Dispositif de mémoire rémanente, comprenant :

un premier substrat (52) et un second substrat (55) disposés parallèlement l'un à l'autre avec un intervalle entre eux;
un support de mémoire (53) prévu entre les premier et le second substrats et formé d'un matériau choisi dans le groupe constitué par un composé de cristal liquide et un composite comprenant un composant de cristal liquide dans une seule molécule;
une contre-électrode (51) prévue sur une surface du premier substrat (52), la surface étant en regard du support de mémoire;
un moyen de chauffage prévu sur le second substrat et comprenant une pluralité d'électrodes inférieures (42) en forme de bandes, isolées l'une de l'autre et agencées en parallèle l'une avec l'autre, une pluralité d'électrodes supérieures (41) en forme de bandes, agencées perpendiculairement aux électrodes inférieures, et une couche génératrice de chaleur (44) prise en sandwich entre les électrodes supérieures et les électrodes inférieures de manière à recevoir du courant des électrodes supérieures et des électrodes inférieures au niveau de leurs intersections, le moyen de chauffage étant prévu pour transcrire des données dans le support de mémoire en chauffant le support de mémoire et en modifiant ainsi une phase du support de mémoire; et
un moyen de lecture pour lire les données transcrites dans le support de mémoire;

**caractérisé en ce que** le dispositif de mémoire comprend par ailleurs un film (54) isolant de l'électricité appliqué sur les électrodes inférieures (42), le film isolant étant appliqué dans des zones où les électrodes supérieures (41) ne recouvrent pas les électrodes inférieures (42); et en ce que le moyen de lecture est à même de détecter électriquement une modification d'une propriété du support de mémoire en utilisant la contre-électrode et une ou plusieurs des électrodes supérieures.

**2.** Dispositif de mémoire rémanente selon la revendication 1, dans lequel le moyen de lecture détecte une différence entre une constante diélectrique du support de mémoire dans une structure monodomaniale et une constante diélectrique du support de mémoire dans une structure polydomaniale.

**3.** Dispositif de mémoire rémanente selon la revendication 1, dans lequel le support de mémoire est formé d'un matériau choisi dans le groupe constitué par un cristal liquide nématique polymère, un cristal liquide smectique polymère, un cristal liquide cholestérique polymère, un cristal liquide comprenant au moins deux types de composants de cristal liquide dans une molécule, et un mélange d'un cristal liquide nématique polymère, d'un cristal liquide smectique polymère et d'un cristal liquide cholestérique polymère.

**4.** Dispositif de mémoire rémanente selon la revendication 1, dans lequel le support de mémoire est formé d'un cristal liquide polymère ferro-électrique.

**5.** Dispositif de mémoire rémanente selon la revendication 4, dans lequel le moyen de lecture détecte une différence entre des constantes diélectriques du cristal liquide polymère ferro-électrique dans différents états d'alignement par l'utilisation de la contre-électrode et des électrodes supérieures.

**6.** Dispositif de mémoire rémanente selon la revendication 4, dans lequel le moyen de lecture détecte une différence entre des degrés de polarisation spontanée du cristal liquide polymère ferro-électrique dans différents états d'alignement par l'utilisation de la contre-électrode et des électrodes supérieures.

**7.** Dispositif de mémoire rémanente selon la revendication 1, dans lequel le support de mémoire est formé d'un composite d'un polymère et d'un composé de cristal liquide.

**8.** Dispositif de mémoire rémanente selon la revendication 7, dans lequel le moyen de lecture détecte une différence entre des constantes diélectriques du composé de cristal liquide dans différents états d'alignement par l'utilisation de la contre-électrode et des électrodes supérieures.

**9.** Dispositif de mémoire rémanente selon la revendication 1, dans lequel le support de mémoire est formé d'un cristal liquide polymère conducteur.

**10.** Dispositif de mémoire rémanente selon la revendication 9, dans lequel le moyen de lecture détecte une variation de la conductivité du cristal liquide polymère conducteur par l'utilisation de la contre-électrode et des électrodes supérieures.

**11.** Dispositif de mémoire rémanente selon la revendication 9, dans lequel le support de mémoire est en contact avec un film d'alignement conducteur.

**12.** Dispositif de mémoire rémanente selon la revendication 1, dans lequel le second substrat est un substrat de silicium.

**13.** Dispositif de mémoire rémanente selon la revendication 12, dans lequel le substrat de silicium reçoit un film isolant sur une surface de celui-ci, qui porte les électrodes inférieures.

**14.** Dispositif de mémoire rémanente, comprenant :

un premier substrat (52) et un second substrat (55) disposés parallèlement l'un à l'autre avec un intervalle entre eux;
un support de mémoire (53) prévu entre les premier et le second substrats et formé d'un matériau choisi dans le groupe constitué par un composé de cristal liquide et un composite comprenant un composant de cristal liquide dans une seule molécule;
une contre-électrode (51) prévue sur une surface du premier substrat (52), la surface étant en regard du support de mémoire;
un moyen de chauffage prévu sur le second substrat et comprenant une pluralité d'électrodes inférieures (42) en forme de bandes, isolées l'une de l'autre et agencées en parallèle l'une avec l'autre, une pluralité d'électrodes supérieures (41) en forme de bandes, agencées perpendiculairement aux électrodes inférieures, et une couche génératrice de chaleur (44) prise en sandwich entre les électrodes supérieures et les électrodes inférieures de manière à recevoir du courant des électrodes supérieures et des électrodes inférieures au niveau de leurs intersections, le moyen de chauffage étant prévu pour transcrire des données dans le support de mémoire en chauffant le support de mémoire et en modifiant ainsi une phase du support de mémoire; et
un moyen de lecture pour lire les données transcrites dans le support de mémoire en détectant par voie optique une transition de phase du support de mémoire; caractérisé en ce que le dispositif de mémoire comprend par ailleurs un film (54) isolant de l'électricité appliqué sur les électrodes inférieures (42), le film isolant étant appliqué dans des zones où les électrodes supérieures ne recouvrent pas les électrodes inférieures.

**15.** Dispositif de mémoire rémanente selon la revendication 14, dans lequel le moyen de lecture détecte optiquement un état non transparent et un état transparent du support de mémoire.

**16.** Dispositif de mémoire rémanente selon la revendication 14, dans lequel le support de mémoire est formé d'un matériau choisi dans le groupe constitué par un cristal liquide nématique polymère, un cristal liquide smectique polymère, un cristal liquide cholestérique polymère, un cristal liquide comprenant au moins deux types de composants de cristal liquide dans une molécule, et un mélange d'un cristal liquide nématique polymère, d'un cristal liquide smectique polymère et d'un cristal liquide cholestérique polymère.

**17.** Dispositif de mémoire rémanente selon la revendication 14, dans lequel le support de mémoire est formé d'un cristal liquide polymère ferro-électrique.

**18.** Dispositif de mémoire rémanente selon la revendication 14, dans lequel le support de mémoire est formé d'un composite d'un polymère et d'un composé de cristal liquide.

**19.** Dispositif de mémoire rémanente selon la revendication 14, dans lequel le support de mémoire est formé d'un cristal liquide polymère conducteur.

**20.** Dispositif de mémoire rémanente selon la revendication 19, dans lequel le support de mémoire est en contact avec un film d'alignement conducteur.

**21.** Dispositif de mémoire rémanente selon la revendication 14, dans lequel le second substrat est un substrat de silicium.

**22.** Dispositif de mémoire rémanente selon la revendication 21, dans lequel le substrat de silicium reçoit un film isolant sur la surface de celui-ci, qui porte l'électrode inférieure.

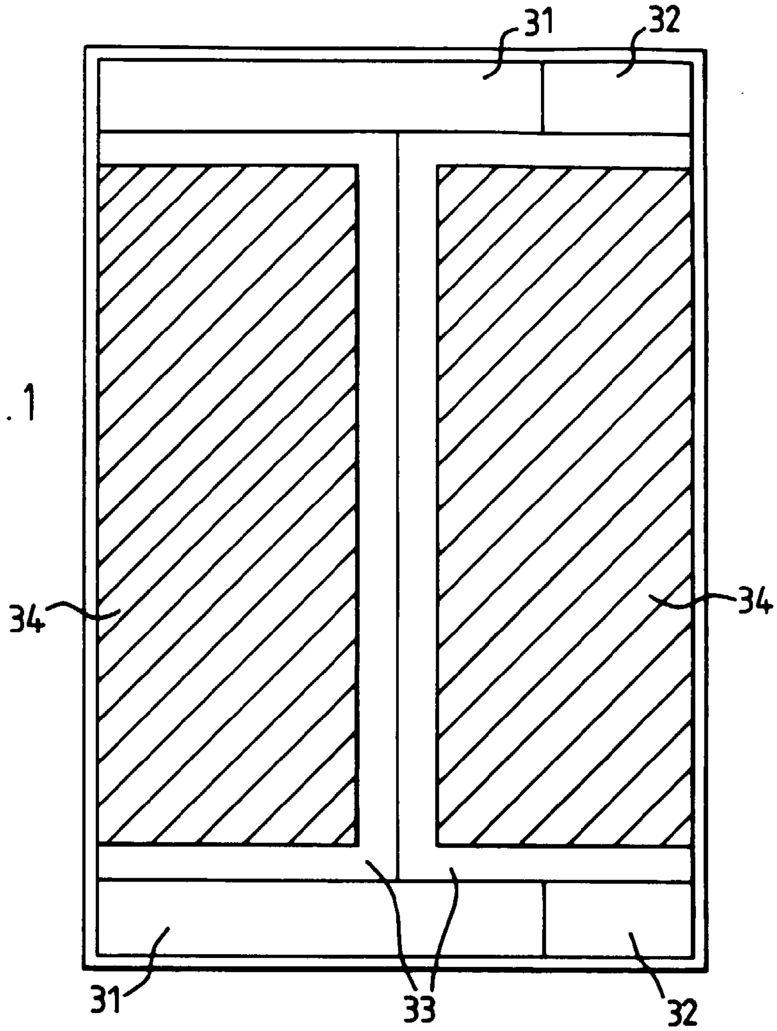
31
32
34
34
31
33
32

FIG.1

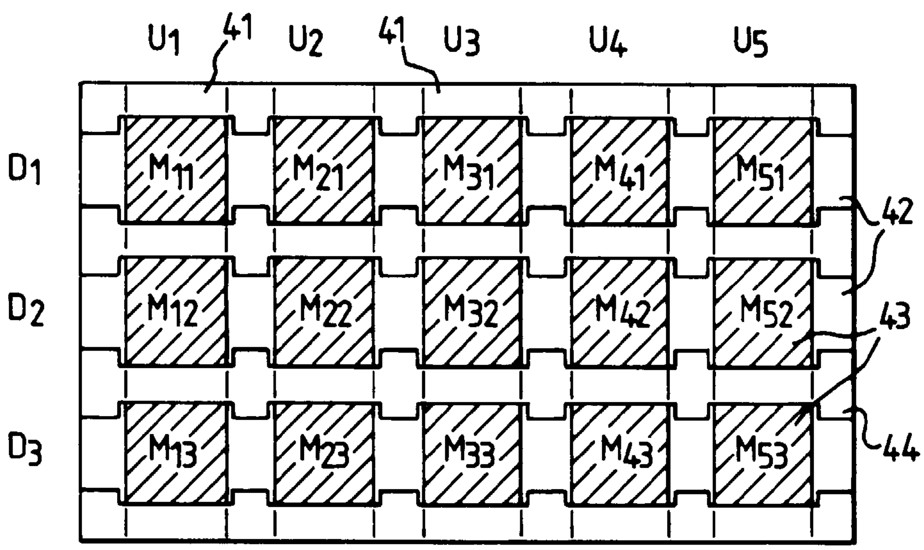
U1
41
U2
41
U3
U4
U5
D1
D2
D3
M11
M21
M31
M41
M51
M12
M22
M32
M42
M52
M13
M23
M33
M43
M53
42
43
44

FIG.2

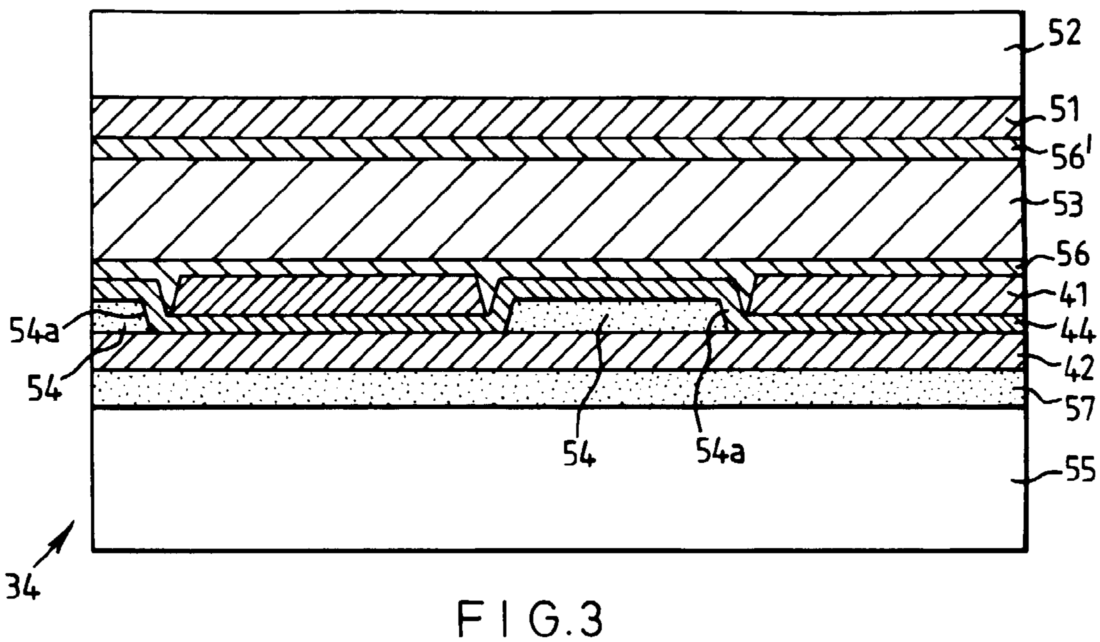
52
51
56'
53
56
41
44
42
57
55
54a
54
54
54a
34

F I G.3

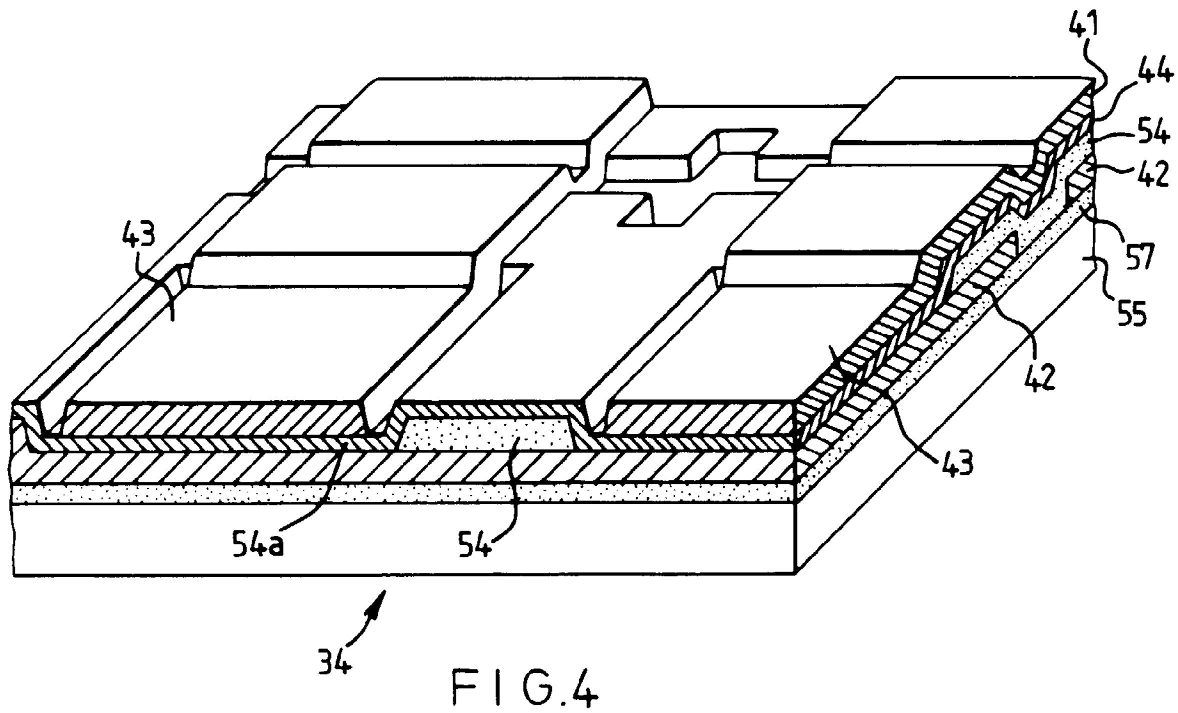
41
44
54
42
57
55
42
43
43
54a
54
34

F I G.4

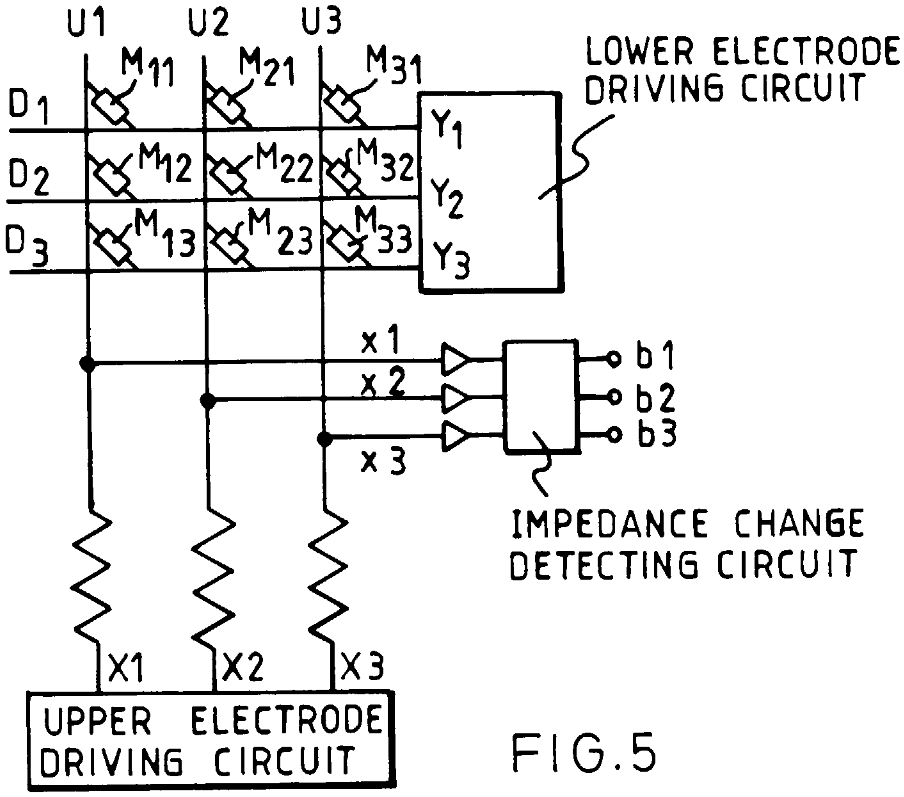
U1
U2
U3
M11
M21
M31
D1
D2
D3
M12
M22
M32
M13
M23
M33
Y1
Y2
Y3
LOWER ELECTRODE DRIVING CIRCUIT
x1
x2
x3
b1
b2
b3
IMPEDANCE CHANGE DETECTING CIRCUIT
X1
X2
X3
UPPER ELECTRODE DRIVING CIRCUIT

FIG.5

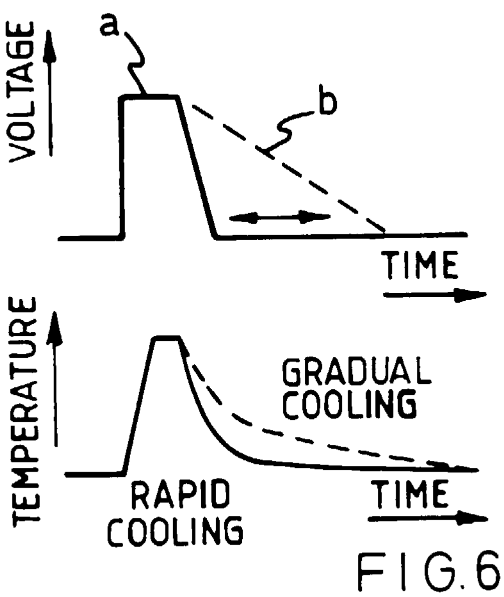
VOLTAGE
a
b
TIME
TEMPERATURE
GRADUAL COOLING
RAPID COOLING
TIME

FIG.6

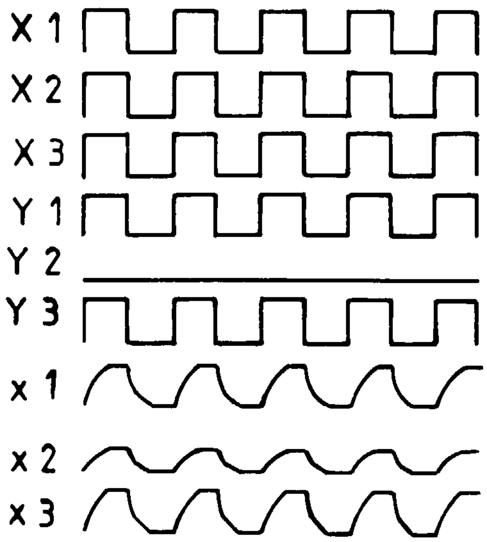

FIG.7

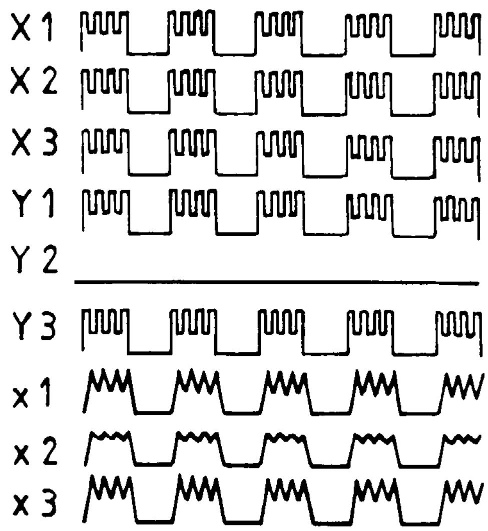

FIG.8

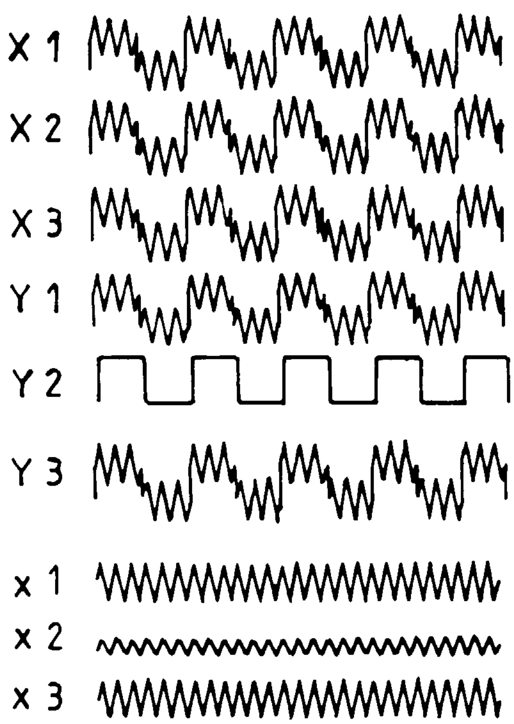

FIG.9

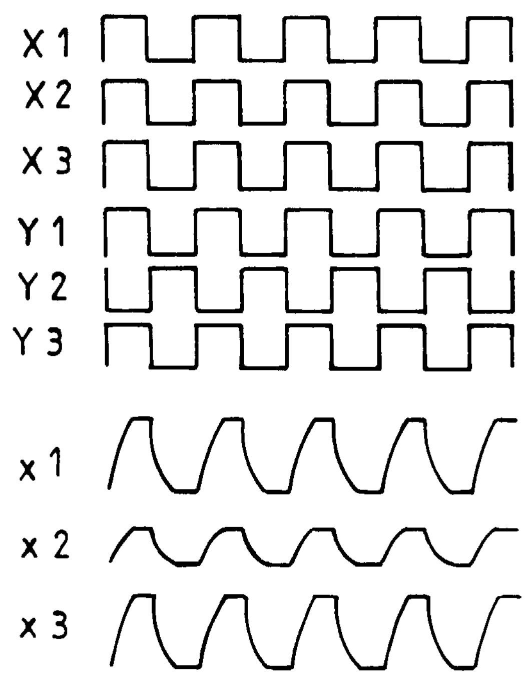

FIG.10

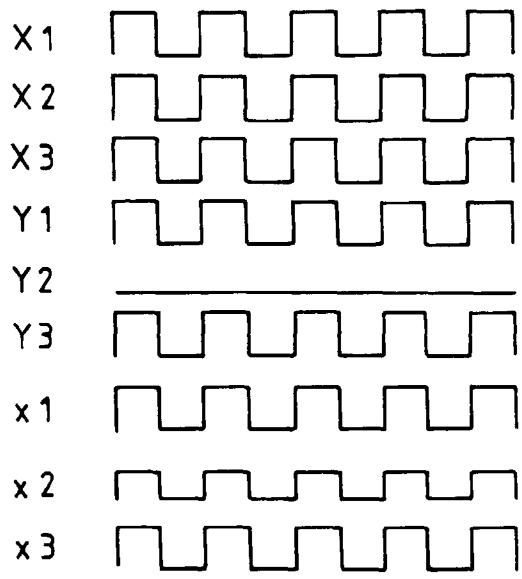


F I G.11

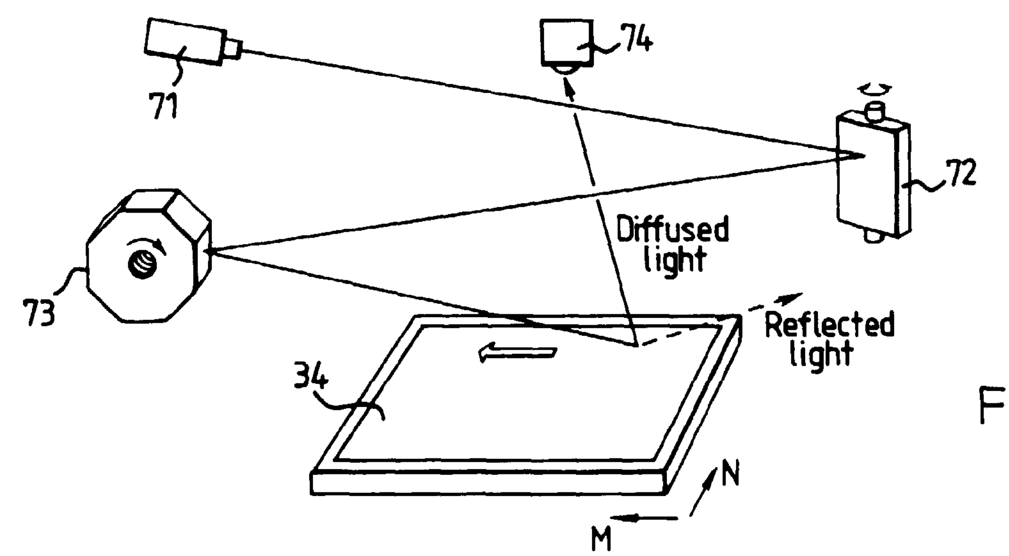


F I G.12

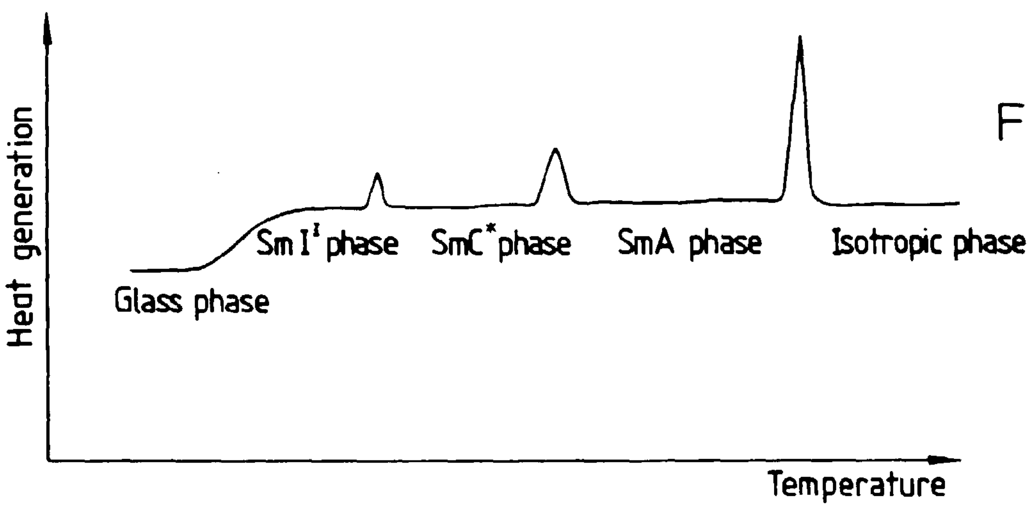


F I G.13

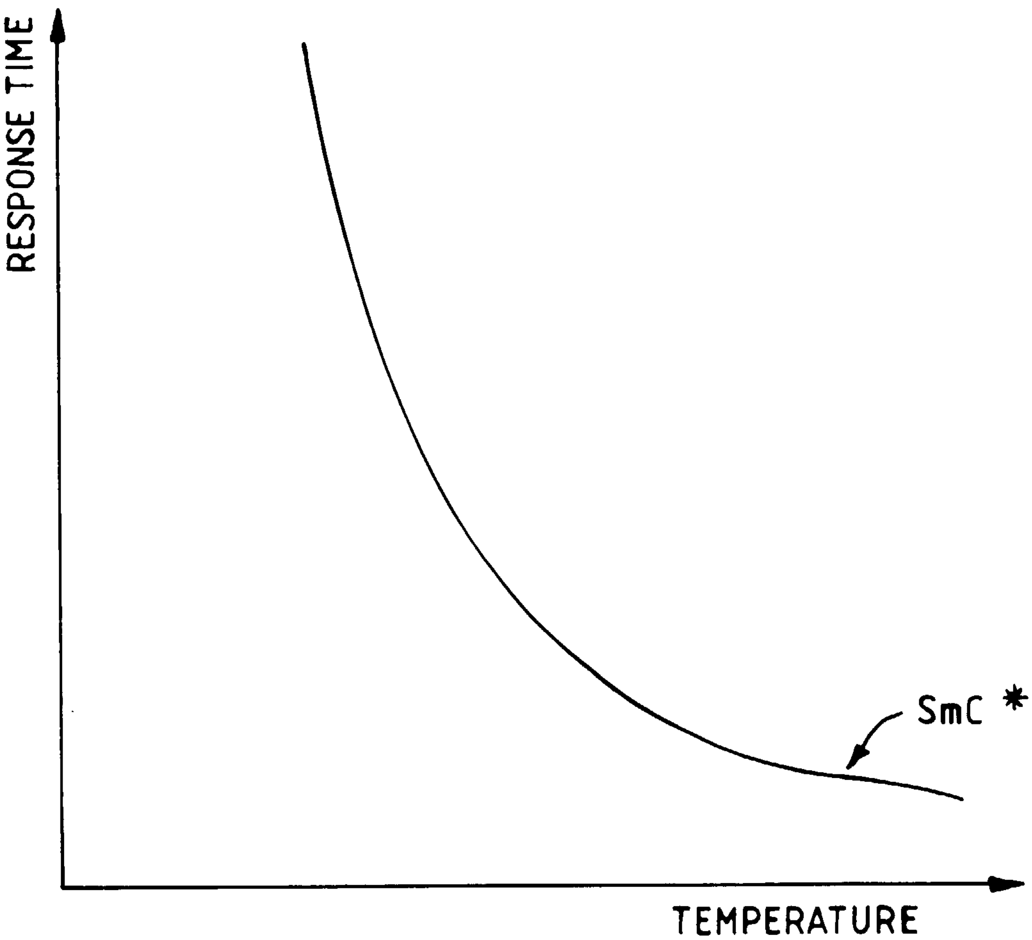
RESPONSE TIME
SmC *
TEMPERATURE

FIG.14

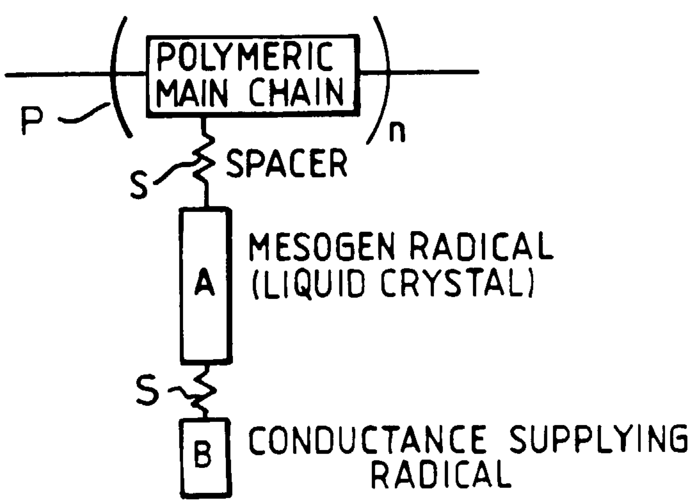
POLYMERIC MAIN CHAIN
P
n
S
SPACER
A
MESOGEN RADICAL (LIQUID CRYSTAL)
S
B
CONDUCTANCE SUPPLYING RADICAL

FIG. 15

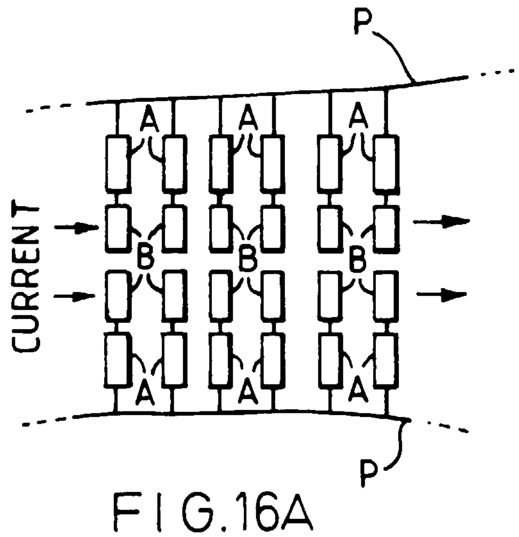


FIG.16A

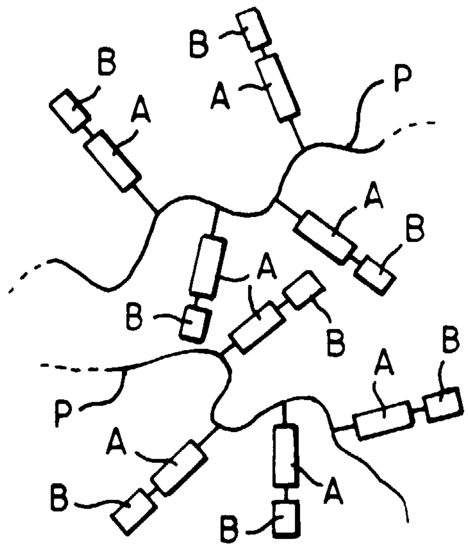


FIG.16B

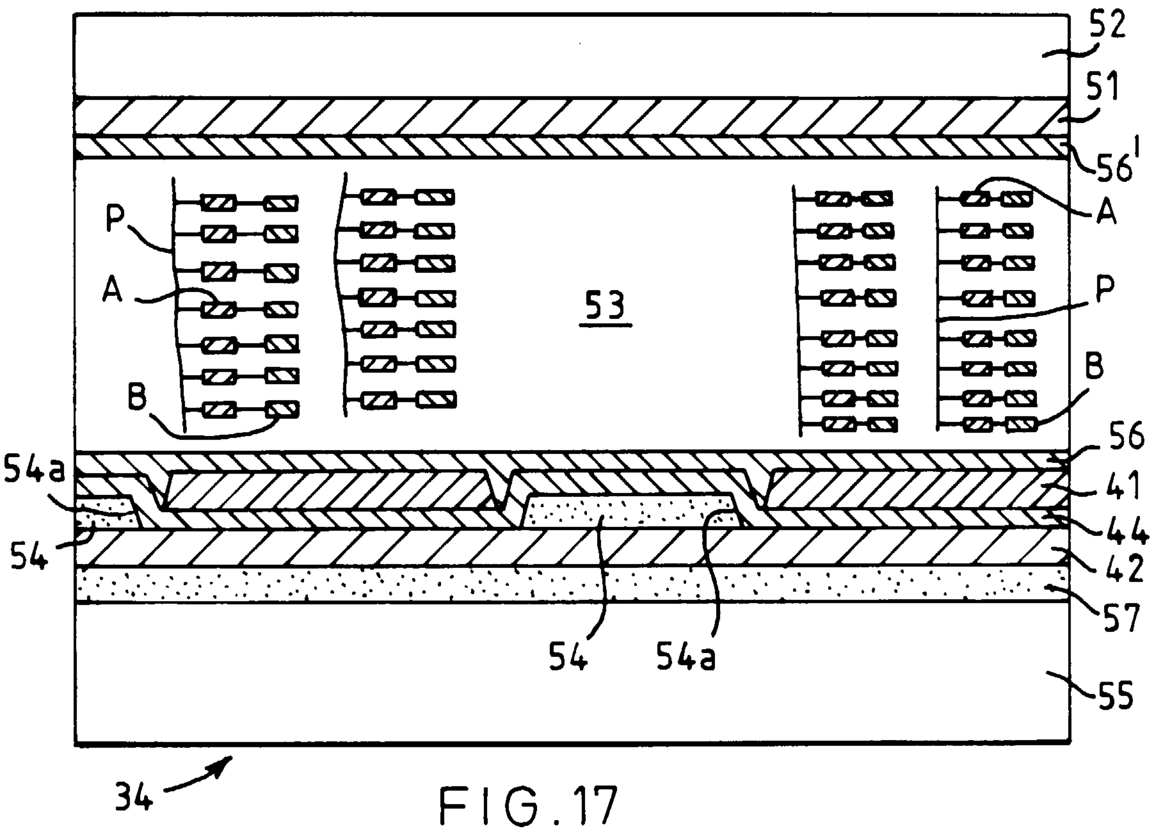


FIG.17

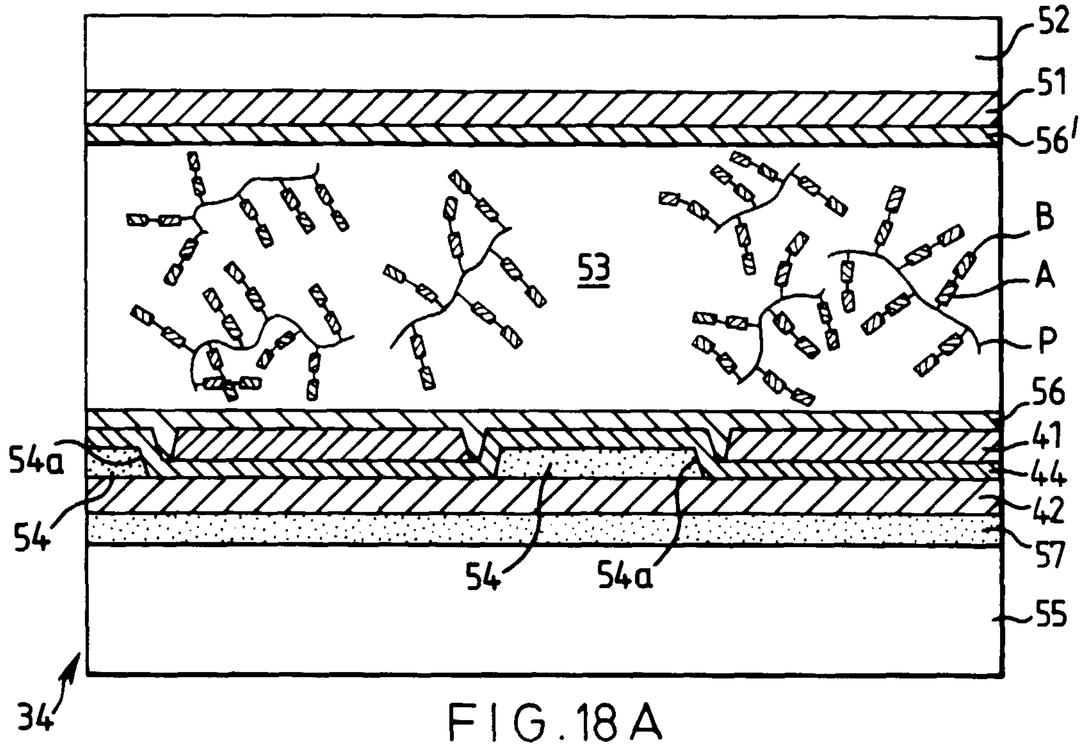


FIG.18A

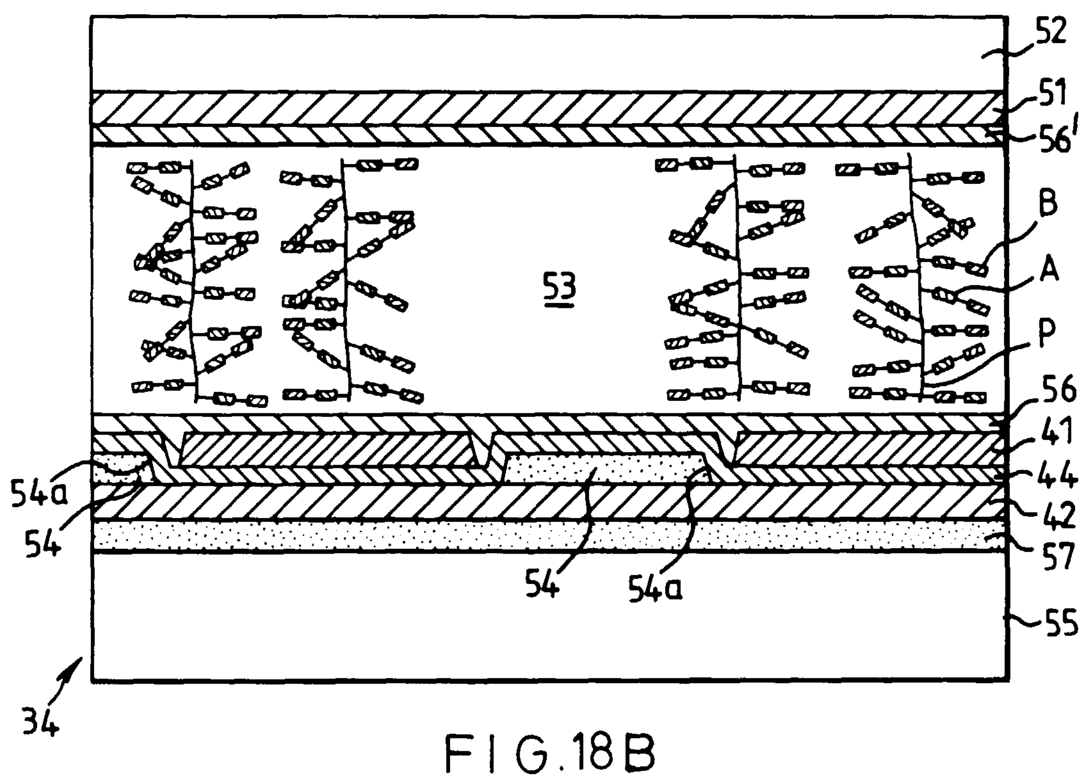


FIG.18B

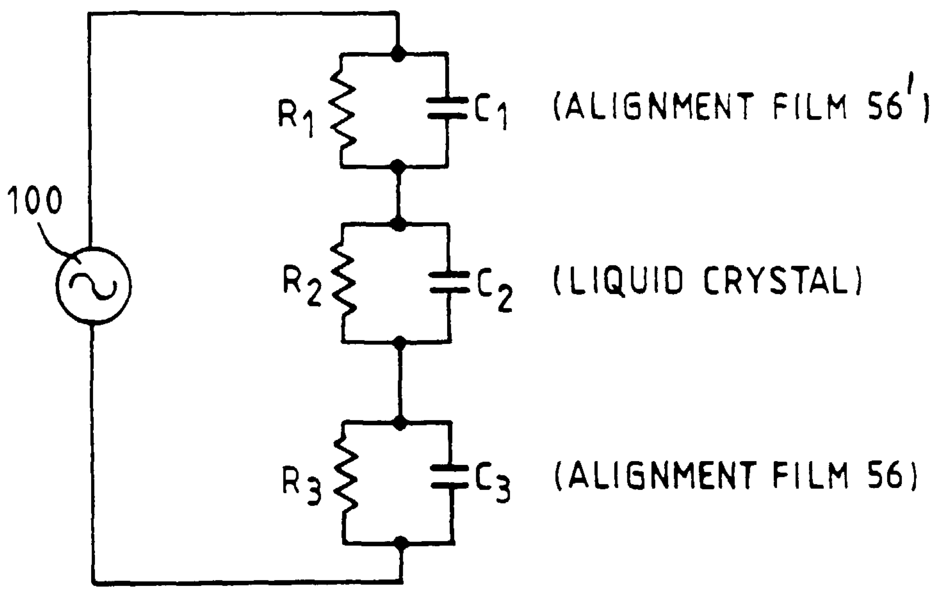
100
R1
C1
(ALIGNMENT FILM 56')
R2
C2
(LIQUID CRYSTAL)
R3
C3
(ALIGNMENT FILM 56)

FIG.19

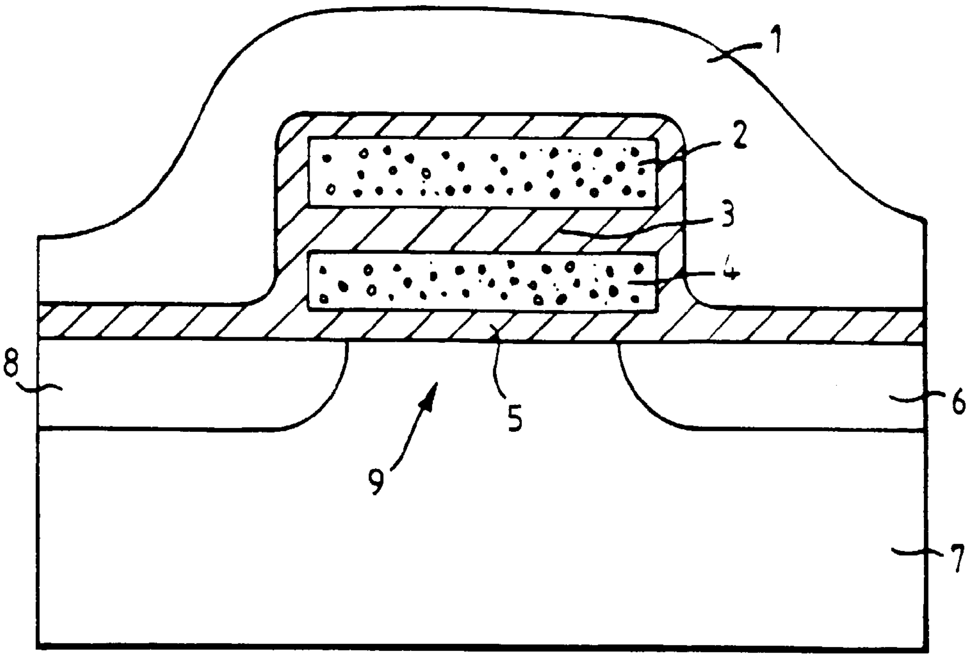


FIG. 20
PRIOR ART

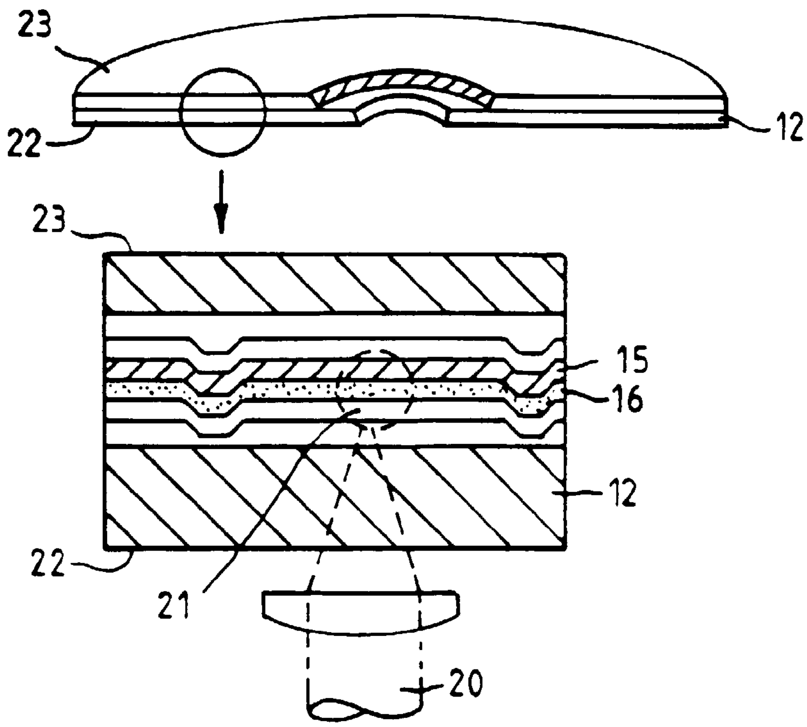


FIG. 21
PRIOR ART